(19) Europäisches Patentamt / European Patent Office / Office européen des brevets

(11) **EP 1 775 833 A1**

(12) **EUROPÄISCHE PATENTANMELDUNG**

(43) Veröffentlichungstag:
**18.04.2007 Patentblatt 2007/16**

(51) Int Cl.:
***H03H 17/04*** *(2006.01)*

(21) Anmeldenummer: **05022259.5**

(22) Anmeldetag: **12.10.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **Infineon Technologies AG**
**81669 München (DE)**

(72) Erfinder: **Träber, Mario**
**82041 Deisenhofen (DE)**

(74) Vertreter: **Reinhard - Skuhra - Weise & Partner**
**Friedrichstrasse 31**
**80801 München (DE)**

(54) **Digitales Filter und Verfahren zum Entwurf digitaler Filter mittels Integrations- und Löschfilter**

(57) Digitales Filter (1, 500) zum Umsetzen eines digitalen Eingangssignals (FIN) in ein digitales Ausgangssignal (FOUT) mit jeweils einer unterschiedlichen Abtastrate mit mehreren Filtereinheiten (9, 17), die in einem Signalpfad zwischen einem Eingang (2) und einem Ausgang (3) des digitalen Filters (1, 500) jeweils voneinander unabhängige Filterfunktionen mit einer vorgegebenen rekursiven Filterordnung (k) realisieren, wobei jede Filtereinheit (9, 17) mindestens ein auf einen vorgebbaren Wert rücksetzbares Verzögerungsglied (12, 23) aufweist, wobei jeder Filtereinheit (9, 17) eine Abtasteinrichtung (8, 18) zugeordnet ist, die das mindestens eine rücksetzbare Verzögerungsglied (12, 23) in Abhängigkeit von einem Abtastratenumsetzfaktor N auf einen vorgegebenen Wert setzt, mit einem an die Abtasteinrichtungen (8, 18) gekoppelten Gewichtungsnetzwerk (4, 19) mit Gewichtungskoeffizienten ($C_{ij}$), wobei das digitale Eingangssignal (FIN) über das Gewichtungsnetzwerk (4) an eine jeweilige Abtasteinrichtung (8) geführt ist oder wobei von einer jeweiligen Abtasteinrichtung (18) ausgegebene digitale interne Abtastsignale ($S_j$) über das Gewichtungsnetzwerk (19) an den Ausgang (3) des digitalen Filters (500) geführt sind, und wobei die Filtereinheiten (9, 17) und die Abtasteinrichtungen (8, 18) mit einer ersten Taktrate und das Gewichtungsnetzwerk (4, 19) mit einer zweiten Taktrate betrieben sind.

FIG 1

EP 1 775 833 A1

**Beschreibung**

Die vorliegende Erfindung betrifft ein digitales Filter zum Umsetzen eines digitalen Eingangssignals in ein digitales Ausgangssignal mit jeweils einer unterschiedlichen Abtastrate. Ferner schafft die Erfindung ein Verfahren zum Bestimmen von Filterkoeffizienten und ein Entwurfsverfahren zum Ausbilden erfindungsgemäßer digitaler Filter.

Bei der digitalen Signalverarbeitung sind häufig Signale mit im Signalverarbeitungspfad unterschiedlichen Taktfrequenzen zu verarbeiten. Bei beispielsweise DSL-Technologien müssen Signale einer Abtastratenumsetzung unterzogen werden, um von einer Taktdomäne, welche mit einer Basisbandfrequenz betrieben wird, an eine weitere Taktdomäne mit einer höheren Abtastfrequenz weitergeleitet werden. Abtastratenumsetzungen erfolgen mittels Interpolations- oder Dezimationsfilter. Ein Interpolationsfilter erzeugt aus einem Datenstrom niedrigerer Abtastrate einen Datenstrom mit höherer Abtastrate, wobei aus dem Eingangssignal Zwischenwerte ermittelt werden und als Ausgangsbitstrom mit hoher Abtastrate ausgegeben werden. Dabei wird das Signal gemäß einer Filterfunktion des Interpolationsfilters gefiltert. Dezimationsfilter erzeugen aus einem Signal hoher Abtastrate unter Filterung mit einer Filterfunktion ein Ausgangssignal mit niedrigerer Abtastrate. Das Verhältnis der Abtastrate des Eingangssignals mit dem Ausgangssignal wird als Abtastratenumsetzfaktor bezeichnet.

Um eine vorgegebene Filterfunktion für ein entsprechendes Interpolation- oder Dezimationsfilter zu erzielen, sind in der Regel viele Filterstufen erforderlich, die nacheinander geschaltet mehrere Abtastratenumsetzungen und Filterungen durchführen. Diese nach dem Stand der Technik übliche Abtastratenumsetzung ist erforderlich, da die verschiedenen Filter der Filterstufen nur in gewissen Frequenzbereichen effizient sind. Beispielsweise werden bei einem Up-Sampling, also einer Interpolation des Eingangssignals von einem Basisbandprozessor zu einem Prozessor mit höherer Abtastrate im Signalpfad ein FIR-Filter, ein Wellendigitalfilter (Wave Digital Filter) und beispielsweise ein Kammfilter (Comb Filter) vorgesehen. Diese Filter weisen zum Beispiel Ketten von rückgekoppelten Verzögerungsgliedern als Integratorstufen auf.

Beim Hintereinanderschalten von derartigen Integratorstufen in Interpolations- oder Dezimationsfiltern wird jeweils die Bitbreite durch den Integrationsvorgang erhöht, was nachteilig breitere Speicher für die Verzögerungsglieder bedingt. Für den einfachen Fall einer Combfilterfunktion zweiter Ordnung wurde daher in "Voiceband Codec with Digital Filtering", Candy et al. in IEEE Transactions on Communications Vol. com. -29, No. 6, June 1981 ein Dezimationsfilter vorgeschlagen, bei dem durch Rücksetzen von als Verzögerungsglieder eingesetzte Registern eine notwendige Signalbitbreite begrenzt wird. Um die in dem Dokument erforderliche Filtercharakteristik zu erzielen, sind jedoch weitere Tiefpassfilter vierter Ordnung und Hochpassfilter zweiter Ordnung in einem Signalpfad von hoher zu niedriger Abtastrate erforderlich.

Um Signalverarbeitungsprozessoren heutzutage jedoch flexibel einsetzen zu können, ist einerseits eine flexible Anpassung der Filtercharakteristik mit einer vorgegebenen Filterfunktion oder Impulsantwortfunktion erwünscht, wobei der Rechen- und Speicheraufwand möglichst gering sein soll. Ein Nachteil von Integratorstufen aus rückgekoppelten Verzögerungsgliedern besteht ferner darin, dass sich auftretende Quantisierungsfehler durch die Integration immer fortsetzen und nicht korrigiert werden können.

Es ist daher eine Aufgabe der vorliegenden Erfindung, ein digitales Filter zu schaffen, das eine Abtastratenumsetzung mit einer beliebigen Filtercharakteristik realisiert, wobei eine maximal benötigte Bitbreite im Signalpfad niedrig ist. Eine weitere Aufgabe besteht darin, einen vorgegebenen Abtastratenumsetzfaktor in nur einer Abtastratenumsetzfilterstufe zu verwirklichen.

Ferner liegt der Erfindung die Aufgabe zugrunde, ein Verfahren zum Entwurf und zur Bestimmung von Filterkoeffizienten für ein erfindungsgemäßes digitales Filter bereitzustellen.

Erfindungsgemäß werden diese Aufgaben durch ein digitales Filter mit den Merkmalen der Patentansprüche 1 und 28, ein Verfahren zum Bestimmen von Filterkoeffizienten gemäß Patentanspruch 35 und ein Verfahren zum Entwerfen eines erfindungsgemäßen digitalen Filter nach dem Anspruch 45 gelöst.

Demgemäß ist ein digitales Filter zum Umsetzen eines digitalen Eingangssignals in ein digitales Ausgangssignal mit jeweils einer unterschiedlichen Abtastrate vorgesehen, mit:

a) einem digitalen Filter zum Umsetzen eines digitalen Eingangssignals in ein digitales Ausgangssignal mit jeweils einer unterschiedlichen Abtastrate mit mehreren Filtereinheiten, die in einem Signalpfad zwischen einem Eingang und einem Ausgang des digitalen Filters jeweils voneinander unabhängige Filterfunktionen mit einer vorgegebenen rekursiven Filterordnung realisieren, wobei jede Filtereinheit mindestens ein auf einen vorgebbaren Wert rücksetzbares Verzögerungsglied aufweist,

b) wobei jeder Filtereinheit eine Abtasteinrichtung zugeordnet ist, die das mindestens eine rücksetzbare Verzögerungsglied in Abhängigkeit von einem Abtastratenumsetzfaktor N auf einen vorgegebenen Wert setzt,

c) mit einem an die Abtasteinrichtungen gekoppelten Gewichtungsnetzwerk mit Gewichtungskoeffizienten, wobei das digitale Eingangssignal über das Gewichtungsnetzwerk an eine jeweilige Abtasteinrichtung geführt ist oder wobei von einer jeweiligen Abtasteinrichtung ausgegebene digitale interne Abtastsignale über das Gewichtungsnetzwerk an den Ausgang des digitalen Filters geführt sind, und

d) wobei die Filtereinheiten und die Abtasteinrichtungen mit einer ersten Taktrate und das Gewichtungsnetzwerk mit einerzweiten Taktrate betrieben sind.

Eine wesentliche der Erfindung zugrunde liegende Idee besteht darin, eine erwünschte Filterfunktion des digitalen Filter aus voneinander unabhängigen Filterfunktionen der Filtereinheiten zusammenzusetzen. Durch das Rücksetzen dieser Filtereinheiten wird einerseits verhindert, dass sich Quantisierungsfehler über viele Taktperioden fortsetzen und andererseits, dass eine Bitbreite des bei der Verarbeitung entstehenden Signals erheblich ansteigt. Das erfindungsgemäße digitale Filter ist derart aufgebaut, dass sowohl eine Interpolation mit einem Interpolationsfaktor erfolgen kann, falls das Eingangssignal über das Gewichtungsnetzwerk den Abtasteinrichtungen zugeführt wird, wie auch die Ausbildung eines Dezimationsfilters mit einem Dezimationsfaktor N, wobei das Eingangssignal zunächst durch die Filtereinheiten geführt wird und dann über die Abtasteinrichtungen in das Gewichtungsnetzwerk eingekoppelt wird, welches dann das dezimierte Ausgangssignal bestimmt.

Bei dem erfindungsgemäßen digitalen Filter wird das Gewichtungsnetzwerk mit der höheren Abtastrate bzw. Taktfrequenz betrieben, und die Filtereinheiten, welche in der Regel Speicher- oder Verzögerungseinrichtungen aufweisen, mit der niedrigeren Abtast- bzw. Taktrate betrieben. Das erfindungsgemäße digitale Filter hat insbesondere den Vorteil, dass durch Auswahl der Gewichtungskoeffizienten beliebige Zielimpulsantwortfunktionen erreicht werden können. Es sind daher um einen vorgegebenen Interpolations- oder Dezimationsfaktor zu erreichen, nicht mehrere Filter und Umsetzer notwendig, sondern lediglich ein erfindungsgemäßes digitales Filter mit einer Taktdomäne der ersten Taktrate und einer Taktdomäne der zweiten Taktrate. Die jeweiligen durch das Gewichtungsnetzwerk erzeugten Signale können bei einer parallelen Ausführung des erfindungsgemäßen Filters auch gleichzeitig bestimmt oder berechnet werden und dann zu den jeweiligen Intepolations- oder Dezimationsabgriffen bereitgestellt werden.

Bevorzugterweise haben die Filtereinheiten zueinander orthogonale Filterfunktionen. Beispielsweise kann eine jeweilige Filtereinheit eine Tschebyscheff-, Butterworth- oder Bessel-Filterfunktion der jeweiligen vorgegebenen Ordnung realisieren.

Besonders bevorzugt wird mindestens eine Filtereinheit als Integrations- und Löschfilter (IAD: integrate-and- dump) ausgeführt. Prinzipiell lässt sich das erfindungsgemäße Filter mit allen möglichen Filtereinheiten ausführen, welche Impulsantwortfunktionen aufweisen, die es erlauben, durch eine Linearkombination eine vorgegebene Zielimpulsantwortfunktion anzunähern. Integrations- und Löschfilter haben den Vorteil, dass eine entsprechende Filtereinheit jeweils auf einen vorgegebenen Wert zurückgesetzt wird, was beispielsweise Null sein kann oder ein Wert, der durch das Gewichtungsnetzwerk an die Abtasteinrichtung geführt ist.

In einer bevorzugten Ausführungsform weist eine als Integrations- und Löschfilter ausgeführte Filtereinheit eine Filterfunktion bzw. eine Impulsantwortfunktion gemäß $H_{DI}^{k,N}(z) = \sum_{n=0}^{N-1} \binom{n+k-1}{K-1} z^{-n}$ auf. Dabei ist K die rekursive Ordnung der Filtereinheit und N der jeweilige Abtastratenumsetzfaktor.

In einer weiteren bevorzugten Ausführungsform weist eine jeweilige Filtereinheit eine der vorgegebenen rekursiven Ordnung entsprechende Anzahl von rücksetzbaren Verzögerungsgliedern auf, welche rückgekoppelt zu einer Integratoreinrichtung verschaltet sind. Dabei erzeugt eine jeweilige zugeordnete Abtasteinrichtung ein Rücksetzsignal für die Verzögerungsglieder. Dieses Rücksetzsignal kann bei der Ausführung als Dezimationsfilter ein Reset- oder ein Zu-Null-Setz-Signal sein, oder bei Interpolationsfiltern ein Vorladesignal, dessen Wert durch das Gewichtungsnetzwerk vorgegeben ist. Das Ausgangssignal des digitalen Filters wird dann als Summe der Ausgangssignale der als Integratoreinrichtung geschalteten Filtereinheit gebildet.

In einer besonders bevorzugten Ausführungsform weist eine jeweilige Filtereinheit genau ein rückgekoppeltes Verzögerungsglied auf. In diesem Fall lassen sich die miteinander verknüpften rückgekoppelten Verzögerungsglieder mit ihren zugeordneten Abtasteinrichtungen jeweils als Integrations- und Löschfilter auffassen.

In noch einer weiteren bevorzugten Ausführungsform des erfindungsgemäßen digitalen Filters sind die Filtereinheiten zu einer Integratorstufe zusammengefasst. Darin sind eine Anzahl von einzeln rückgekoppelten rücksetzbaren Verzögerungsgliedern vorgesehen, die einer maximalen vorgegebenen rekursiven Ordnung des erfindungsgemäßen Filters entspricht. Eine jeweilige zugeordnete Abtasteinrichtung ist an einen Eingang eines jeweiligen rückgekoppelten Verzögerungsgliedes gekoppelt und von der Abtasteinrichtung auf einen Vorladewert gesetzt oder auf Null zurückgesetzt.

In einer Weiterbildung des erfindungsgemäßen Filters ist jedem rückgekoppelten rücksetzbaren Verzögerungsglied der Integratorstufe ausgangsseitig eine Verschiebeeinrichtung nachgeschaltet. Diese Verschiebeeinrichtung verschiebt ein jeweiliges digitales Signal um eine vorgegebene Anzahl von Bits. Dadurch wird erreicht, dass die durch die jeweilige Integration durch ein rückgekoppeltes Verzögerungsglied erhöhte Bitbreite zunächst vermindert wird. Der Dynamikumfang der jeweiligen Integrations- und Löschfilterkette in der Integratorstufe wird so reduziert. Durch die Verschiebeeinrichtungen werden ferner die Anforderungen an die Genauigkeit oder Quantisierung der Gewichtungskoeffizienten herabgesetzt. Die Anzahl der Bits, welche zum Darstellen der Gewichtungskoeffizienten benötigt werden, ist dadurch verringert.

In einer ersten alternativen Ausführungsform ist das digitale Filter als Interpolationsfilter ausgeführt, wobei das Gewichtungsnetzwerk eine an den Eingang des Filters gekoppelte Verzögerungsgliedkette von seriell geschalteten Verzögerungsgliedern aufweist, wobei an Leitungsknoten der Verzögerungsgliedkette verzögerte interne Signale abgreifbar sind, und

wobei das Gewichtungsnetzwerk derart Vorladesignale für die Abtasteinrichtungen erzeugt, dass ein jeweiliges Vorladesignal einer Summe der mit Gewichtungskoeffizienten gewichteten verzögerten internen Signale entspricht.

Das Gewichtungsnetzwerk nimmt demgemäß jeweils um einen Verzögerungsfaktor verzögerte Eingangssignale an und bildet daraus jeweils Linearkombinationen, die durch die jeweiligen Vorladesignale dargestellt sind.

Die rücksetzbaren Verzögerungsglieder sind dann vorzugsweise jeweils zu jedem N-ten Takt durch die zugeordnete Abtasteinrichtung auf einen dem Vorladesignal entsprechenden Wert zurückgesetzt.

In einer zweiten alternativen Ausführungsform ist das digitale Filter als Dezimationsfilter ausgeführt, wobei das Gewichtungsnetzwerk eine an den Ausgang des Filters gekoppelte Verzögerungsgliedkette von seriell geschalteten Verzögerungsgliedern aufweist, wobei Leitungsknoten zwischen den Verzögerungsgliedern der Verzögerungsgliedkette vorgesehen sind, und

wobei das Gewichtungsnetzwerk derart Segmentsignale für die Leitungsknoten der Verzögerungsgliedkette erzeugt, dass ein jeweiliges Segmentsignal einer Summe der mit Gewichtungskoeffizienten gewichteten internen Abtastsignale entspricht.

Die Struktur des Gewichtungsnetzwerks entspricht im Wesentlichen der bei der Interpolation verwendeten Ausführung, wobei insbesondere die Gewichtungskoeffizienten prinzipiell dieselben sind. Die Segmentsignale entsprechen dabei Linearkombinationen der durch die Filtereinheiten bereitgestellten und von der jeweiligen Abtasteinrichtung aufgetasteten Signale.

Dabei werden vorzugsweise die rücksetzbaren Verzögerungsglieder jeweils zu einem N-ten Takt durch die zugeordnete Abtasteinrichtung auf Null zurückgesetzt.

Vorzugsweise weist die Verzögerungsgliedkette eine Anzahl von Verzögerungsgliedern auf, welche einer maximalen vorgegebenen rekursiven Filterordnung entspricht. Somit wird eine quadratische Matrix von Gewichtungskoeffizienten für das Gewichtungsnetzwerk benötigt. Prinzipiell ist jedoch auch eine Ausführung mit weniger Verzögerungsgliedern möglich wodurch die Gewichtungskoeffzienten-Matrix kleiner ausfällt.

Bevorzugt wird jedem Gewichtungskoeffizienten, welcher ungleich Null ist, ein Multiplizierer und ein Addierer zugeordnet. Der jeweilige Multiplizierer gewichtet ein entsprechendes Signal im Gewichtungsnetzwerk mit dem Gewichtungskoeffizienten, und der jeweilige Addierer dient der Realisierung einer jeweiligen Summe in der oben genannten Linearkombination.

In noch einer Weiterbildung des erfindungsgemäßen Filters ist jeder Filtereinheit ausgangsseitig eine Verschiebeeinrichtung nachgeschaltet, welche jeweils ein digitales Signal um eine vorgegebene Anzahl von Bits verschiebt. Diese Verschiebung dient der Begrenzung oder Reduzierung der Bitbreite der Gewichtungskoeffizienten sowie der Reduzierung der Dynamik der Filtereinheiten, d. h. eine Begrenzung der jeweiligen notwendigen Bitbreiten der Ausgangssignale der Filtereinheiten.

Vorzugsweise entspricht die Anzahl N der Abtasteinrichtungen einer vorgegebenen Approximationsfilterordnung, mit welcher das digitale Filter eine Zielfilterfunktion realisiert.

In einer besonders bevorzugten Ausführungsform approximiert das erfindungsgemäße digitale Filter eine L Stützstellen lange Zielfilterfunktion, wobei die Anzahl S der seriellen geschalteten Verzögerungsglieder der Verzögerungsgliedkette $S = \left\lceil \dfrac{L}{N} \right\rceil$ beträgt. Dabei ist S durch Aufrunden von L/N, also der nächstgrößeren ganzzahligen Zahl zu L/N angegeben.

In dieser Weise wird eine vorgegebene Zielfilterfunktion segmentweise approximiert, wobei jedes Segment durch einen Satz von Gewichtungskoeffizienten definiert ist. Es ergeben dann sich Filterordnungen S (N-1).

In einer Weiterbildung des Filters weist das Filter eine symmetrische FIR-Filterfunktion auf, wobei über weitere Abtasteinrichtungen an das Gewichtungsnetzwerk gekoppelte weitere Filtereinheiten vorgesehen sind. Bei einer symmetrischen Impulsantwortfunktion kann bevorzugt die Symmetrie ausgenutzt werden, wodurch gegenüber einer beliebigen Filterfunktion die Anzahl der notwendigen Gewichtungskoeffizienten halbiert werden kann. Dadurch wird auch der Implementierungsaufwand erheblich niedriger.

Dann werden vorzugsweise von dem Gewichtungsnetzwerk derart weitere Vorladesignale für die weiteren Abtasteinrichtungen erzeugt, dass ein jeweiliges weiteres Vorladesignal einer Summe der mit Gewichtungskoeffizienten gewichteten verzögerten internen Signale entspricht, wobei ein jeweiliges gewichtetes verzögertes internes Signal vor der Summation in Abhängigkeit von der Verzögerung des internen verzögerten Signals verzögert wird. Bei dieser symmetrischen Ausführung eines erfindungsgemäßen Interpolationsfilters wird durch die Verzögerung der internen Signale ein bereits approximiertes Segment der vorgegebenen symmetrischen Zielfilterfunktion gespiegelt realisiert.

In einer alternativen Weiterbildung des erfindungsgemäßen Interpolationsfilters ist jeder weiteren Abtasteinrichtung eine weitere Verzögerungsgliedkette mit seriell verschalteten Verzögerungsgliedern zugeordnet, wobei ein jeweiliges weiteres Vorladesignal an der Verzögerungsgliedkette abgreifbar ist. Dabei ist jedem Verzögerungsglied der jeweiligen weiteren Verzögerungsgliedkette eingangsseitig ein mit einem jeweiligen Gewichtungskoeffizienten gewichtetes internes Verzögerungssignal zugeführt. Diese alternative Erzeugung der weiteren Vorladesignale führt ebenfalls zu einer Wiederverwendung von bereits bestimmten Gewichtungskoeffizienten, um ein symmetrisches Segment der Zielimpulsantwortfunktion zu erzeugen.

Vorzugsweise sind die weiteren Abtasteinrichtungen an eine weitere Integratorstufe gekoppelt, welche ausgangsseitig einer Zeitumkehreinrichtung nachgeschaltet ist. Ferner ist bevorzugt ein Addierer vorgesehen, welcher die Ausgangssignale in der Integratorstufe addiert und als das Ausgangssignal des Filters ausgibt. Das Ausgangssignal eines symmetrischen erfindungsgemäßen Interpolationsfilters setzt sich daher aus den beiden Signalen der Integratorstufe und der weiteren Integratorstufe additiv zusammen.

Bei einer bevorzugten Weiterbildung des als Dezimationsfilter ausgeführten erfindungsgemäßen Filters erzeugt das Gewichtungsnetzwerk derartige Segmentsignale, dass ein jeweiliges Segmentsignal einer Summe der mit Gewichtungskoeffizienten gewichteten Summen der internen Abtastsignale mit weiteren verzögerten internen Abtastsignalen entspricht. Dabei wird vor der Summation ein jeweiliges von einer weiteren Abtasteinrichtung erzeugtes weiteres internes Abtastsignal in Abhängigkeit von dem jeweiligen Leitungsknoten der Verzögerungsgliedkette verzögert.

In einer alternativen Ausführungsform der Weiterbildung als Dezimationsfilter ist jeder weiteren Abtasteinrichtung eine weitere Verzögerungsgliedkette mit seriell verschalteten Verzögerungsgliedern zugeordnet, welchen ein jeweiliges weiteres Abtastsignal zugeführt ist. An Ausgängen der weiteren Verzögerungsglieder sind verzögerte interne Abtastsignale abgreifbar, und die Segmentsignale werden derart erzeugt, dass ein jeweiliges Segmentsignal einer Summe der mit den Gewichtungskoeffizienten gewichteten Summe der jeweiligen internen Abtastsignale mit den jeweiligen verzögerten internen Abtastsignalen entspricht. Auch bei einer Ausführung als Dezimationsfilter können die Symmetrieeigenschaften der Zielimpulsantwortfunktion zur Halbierung der Anzahl von notwendigen Gewichtungskoeffizienten verwendet werden.

Alternativ kann bei der als Dezimationsfilter ausgeführten Weiterbildung jeder weiteren Abtasteinrichtung eine weitere Verzögerungsgliedkette mit seriell verschalteten Verzögerungsgliedern zugeordnet werden. Jeder weiteren Verzögerungsgliedkette ist dann ein jeweiliges weiteres Abtastsignal zugeführt, wobei an Ausgängen der weiteren Verzögerungsglieder verzögerte interne Abtastsignale abgreifbar sind. Die Segmentsignale werden derart erzeugt, dass ein jeweiliges Segmentsignal einer Summe der mit den Gewichtungskoeffizienten gewichteten Summen der jeweiligen internen Abtastsignale mit den jeweiligen verzögerten internen Abtastsignalen entspricht.

Die weiteren Abtasteinrichtungen sind dann vorzugsweise an eine weitere Integratorstufe gekoppelt, welcher eingangsseitig eine Zeitumkehreinrichtung vorgeschaltet ist, welche das digitale Eingangssignal des Filters empfängt. Vermittels der Zeitumkehreinrichtung und der zusätzlichen verzögerten weiteren Abtastsignale werden zueinander symmetrische Segmente einer Zielimpulsantwortfunktion derart zusammengesetzt, dass eine approximierte vorgegebene Zielimpulsantwortfunktion durch das erfindungsgemäße Dezimationsfilter approximiert wird.

Vorzugsweise sind die Verzögerungsglieder der weiteren Verzögerungsgliedkette jeweils derart eingerichtet, dass eine Verzögerung um $z^{-2}$ entsprechend der zweiten Taktrate erzeugt wird.

Vorzugsweise weist das Filter eine symmetrische FIR-Filterfunktion auf und die Anzahl S der seriell geschalteten Verzögerungsglieder der Verzögerungsgliedkette beträgt $S = \left\lceil \dfrac{L}{2N} \right\rceil$. Dabei ist S die auf den nächstgrößeren gegenüber L/2N gerundeten Wert einer ganzzahligen Zahl.

Die Erfindung schafft ferner eine Polyphasenfilteranordnung mit einer Anzahl P von Filterzweigen mit jeweils einem erfindungsgemäßen digitalen Filter, mit einer Umschalteinrichtung, welche ein digitales Polyphasenfiltereingangssignal jeweils zeitverzögert als Zweigsignal in die Filterzweige einkoppelt, und mit einer Summiereinrichtung, welche die Ausgangssignale der Filter zu einem Polyphasenfiltereingangssignal zusammenführt. Eine derartige Polyphasenfilteranordnung hat den Vorteil, dass die einzelnen digitalen Filter mit einer reduzierten Taktrate betrieben werden können. Diese ist vorzugsweise um den Faktor P reduziert.

In einer bevorzugten Ausführungsform der erfindungsgemäßen Polyphasenfilteranordnung ist ein für die digitalen Filter der Filterzweige gemeinsames Gewichtungsnetzwerk vorgesehen, welches mit der zweiten Taktrate betrieben ist. Dies hat den Vorteil, dass erheblicher Implementierungsaufwand eingespart wird, da das Gewichtungsnetzwerk nur einmal vorgesehen sein muss. Zudem haben die erfindungsgemäßen digitalen Filter für die Filterzweige den Vorteil, dass sie dieselben Gewichtungskoeffizienten für das gemeinsame Gewichtungsnetzwerk benötigen.

Vorzugsweise sind dann auch für die digitalen Filter der Filterzweige gemeinsame Abtasteinrichtungen vorgesehen. Dann sind vorzugsweise die Abtasteinrichtungen über Schalter an die jeweiligen Filtereinheiten oder an die rückgekoppelten Verzögerungsglieder der jeweiligen Integratoreinrichtungen gekoppelt. Das gemeinsame Gewichtungsnetzwerk wird demnach über die Abtasteinrichtungen an die den jeweiligen Filterzweigen zugeordneten Filtereinheiten eines Filterzweiges oder den jeweiligen Integratoreinrichtungen der Filterzweige gekoppelt.

In einer ersten bevorzugten Ausführungsform ist die Polyphasenfilteranordnung als Interpolationsfilter ausgebildet, wobei jedem Filterzweig eine Gruppe von P seriell verschalteten Verzögerungsgliedern zugeordnet ist, an Leitungsknoten zwischen den Verzögerungsgliedern einer Gruppe jeweils ein Zweigsignal abgreifbar ist, und wobei die Gruppen seriell miteinander an einen Eingang der Polyphasenfilteranordnung verbunden sind.

In einer zweiten bevorzugten Weiterbildung ist die erfindungsgemäße Polyphasenfilteranordnung als Dezimationsfilter ausgebildet, wobei jedem Filterzweig eine Gruppe von P seriell verschalteten Verzögerungsgliedern zugeordnet ist, die Segmentsignale taktweise über zwischen den Verzögerungsgliedern vorgesehene Addierer einer jeweiligen Gruppe zugeführt sind, und wobei die Gruppen seriell miteinander an einen Ausgang der Polyphasenfilteranordnung verbunden sind.

Die jedem Filterzweig zugeordneten P seriell verschalteten Verzögerungsglieder sorgen für die entsprechende Signalphase für den jeweiligen Filterzweig.

Die Erfindung schafft ferner ein Verfahren zum Bestimmen von Filterkoeffizienten eines digitalen Filters, welches eine vorgegebene Zielimpulsantwortfunktion realisiert, mit den Verfahrensschritten:

a) Unterteilen der Zielimpulsantwortfunktion in Segmente, wobei jedes Segment s eine vorgegebene Anzahl von Stützstellen aufweist, und wobei jedem Segment s ein Satz von Gewichtungskoeffizienten zugeordnet ist,

b) Festlegen von unabhängigen Aufbauimpulsantwortfunktionen, welche jeweils eine rekursive Filterordnung k aufweisen und von einem Abtastratenumsetzfaktor N abhängen,

c) Bilden einer Linearkombination der Aufbauimpulsantwortfunktionen für jedes Segment s, wobei die Koeffizienten der Linearkombination den Gewichtungskoeffizienten des jeweiligen Segmentes s entsprechen, und wobei die Gewichtungskoeffizienten $C_{s,k}$ derart gewählt werden, dass die Linearkombination die Zielimpulsantwortfunktion in dem jeweiligen Segment annähert.

Als mögliche Aufbauimpulsantwortfunktionen kommen beispielsweise Tschebyscheffpolynome, Butterworth-, oder Bessel-Filterfunktion in Frage. Bevorzugt werden die Gewichtungskoeffizienten mittels einer Ausgleichsrechnung, insbesondere durch Interpolationen bestimmt. Vorzugsweise kann dazu auch ein Verfahren der kleinsten Abweichungsquadrate eingesetzt werden.

In einer besonders bevorzugten Ausführungsform entsprechen die Aufbauimpulsantwortfunktionen jeweils einem Integrations- und Löschfilter mit einer rekursiven Ordnung k und einer Rücksetzperiode von N. Vorteilhafte unabhängige Aufbauimpulsantwortfunktionen lauten beispielsweise

$$H_{DI}^{K,N}(z) = \sum_{n=0}^{N-1} \binom{n + K - 1}{K - 1} z^{-n} ,$$ wobei K einer vorgegebenen maximalen rekursiven Filterordnung entspricht.

Vorzugsweise hat die Zielimpulsantwortfunktion eine Länge L und die Anzahl S der Segmente beträgt

$$S = \left\lceil \frac{L}{N} \right\rceil .$$

Die Anzahl der Stützstellen bzw. die Länge des jeweiligen Segments entspricht in bevorzugten Ausführungsformen dem Abtastratenumsetzfaktor N. Gegebenenfalls lassen sich auch weitere zu Null gesetzte Stützstellen der Zielimpulsantwortfunktion zufügen, um für jedes Segment genau N Stützstellen bzw. Abgriffe bereitzustellen.

In einer weiteren bevorzugten Ausführungsform ist die Anzahl der Segmente gleich einer vorgegebenen maximalen rekursiven Filterordnung K.

In einer bevorzugten Weiterbildung des erfindungsgemäßen Verfahrens werden die Gewichtungskoeffizienten aus einem Gleichungssystem

$$\underbrace{\begin{pmatrix} h_{s \cdot N+0} \\ h_{s \cdot N+1} \\ \vdots \\ h_{s \cdot N+N-1} \end{pmatrix}}_{\underline{h}} = \underbrace{\begin{pmatrix} w_{0,1} & w_{0,2} & \cdots & w_{0,K} \\ w_{1,1} & w_{1,2} & \cdots & w_{1,K} \\ \vdots & \vdots & \ddots & \vdots \\ w_{N-1,1} & w_{N-1,2} & \cdots & w_{N-1,K} \end{pmatrix}}_{\underline{W}} \cdot \underbrace{\begin{pmatrix} C_{s,0} \\ C_{s,1} \\ \vdots \\ C_{s,K-1} \end{pmatrix}}_{\underline{c}}$$

bestimmt.

Dabei stellt $\underline{h}$ einen Stützstellenvektor, $\underline{c}$ einen Gewichtungskoeffizientenvektor und $\underline{W}$ eine Aufbauimpulsantwortmatrix dar. Es ist $w_{n,K} = \begin{pmatrix} n + K - 1 \\ K - 1 \end{pmatrix}$.

Dieses in Matrixform dargestellte Gleichungssystem lässt sich dann mittels bekannter Verfahren, beispielsweise mittels kleinster Fehlerquadrate näherungsweise lösen.

In noch einer Weiterbildung des Verfahrens wird die Zielimpulsantwortfunktion symmetrisch gewählt und die Gewichtungskoeffizienten derart bestimmt, dass jeweils ein Paar von Gewichtungskoeffizienten denselben Wert aufweist. Eine symmetrische Zielimpulsantwortfunktion ermöglicht die Halbierung der Anzahl von verschiedenen Gewichtungskoeffizienten gegenüber einer beliebigen unsymmetrischen Zielimpulsantwortfunktion.

In einer matrixförmigen Anordnung der Gewichtungskoeffizienten ergibt sich so eine Matrix, die eine gerade Anzahl von Spalten aufweist, wobei die Einträge gegenüber einer senkrechten Mittelachse symmetrisch sind. Besonders bevorzugterweise bestimmt das Verfahren die Gewichtungskoeffizienten für ein erfindungsgemäßes digitales Filter, wobei die Filtereinheiten zu den Aufbauimpulsantwortfunktionen proportionale Filterfunktionen aufweisen, und wobei ein jeweiliges verzögertes internes Signal oder ein jeweiliges Segmentsignal einem Segment S zugeordnet wird.

Die Erfindung schafft darüber hinaus ein Verfahren zum Entwerfen eines erfindungsgemäßen digitalen Filters mit den Verfahrensschritten:

a) Festlegen einer Zielimpulsantwortfunktion, einer maximalen rekursiven Filterordnung K des Abtastratenumsetzfaktors N und einer Anzahl von Segmenten S;

b) Bestimmen der Gewichtungskoeffizienten nach dem oben ausgeführten erfindungsgemäßen Verfahren;

c) Ausbilden eines digitalen Filters mit dem Gewichtungsnetzwerk, wobei für jeden Gewichtungskoeffizienten, welcher ungleich Null ist, ein Multiplizierer und ein Addierer vorgesehen wird und wobei jeweils die Aufbauimpulsantwortfunktionen realisierenden Filtereinheiten vorgesehen werden.

Bevorzugt wird die maximale rekursive Filterordnung derart gewählt, dass eine maximale Abweichung der realisierten Filterimpulsantwortfunktion von der Zielimpulsantwcrtfunktion unterhalb einer vorgegebenen Toleranzschwelle liegt.

Eine vorteilhafte Weiterbildung des Entwurfverfahrens sieht für den Schritt b) für mindestens ein Segment ferner vor:

a) Festlegen eines Probegewichtungskoeffizientensatzes bei dem mindestens einer der K Gewichtungskoeffizienten zu Null gesetzt wird,

b) Bestimmen der nicht zu Null gesetzten Gewichtungskoeffizienten des Probegewichtungskoeffizientensatzes derart, dass die Linearkombination die Zielimpulsantwortfunktion ($H_{IAF}(z)$) in dem jeweiligen Segment annähert,

c) Bestimmen einer jeweiligen maximalen Abweichung der mittels des Probegewichtungskoeffizientensatzes realisierten Filterimpulsantwortfunktion von der Zielimpulsantwortfunktion in dem Segment s.

Diese Weiterbildung liefert den Vorteil, dass Probegewichtungskoeffizientensätze bestimmt werden, bei denen einige Gewichtungskoeffizienten Null sind. Bei der Ausbildung des digitalen Filters kann daher auf Addierer und Multiplizierer verzichtet werden, was einen geringeren Implementierungsaufwand bedeutet.

Bevorzugt werden Probegewichtungskoeffizientensätze bestimmt, dass für alle Kombinationen von zu Null gesetzten Gewichtungskoeffizienten die jeweilige maximale Abweichung bestimmt wird. Für jedes Segment s mit beispielsweise k zugeordneten Gewichtungskoeffizienten sind daher k! Probegewichtungskoeffizientensätze zu bewerten.

Vorzugsweise werden für die Realisierung des Gewichtungsnetzwerkes diejenigen Progewichtungskoeffizientensätze ausgewählt, die die höchste Anzahl von zu Null gesetzten Gewichtungskoeffizienten aufweisen, wobei die maximalen Abweichungen unterhalb einer vorgegebenen Toleranzschwelle liegen.

Obwohl beim Entwurf dadurch zunächst umfangreiche Berechnungen zur Bewertung der Probegewichtungskoeffzientensätze durchgeführt werden, liefert das Verfahren für die jeweilige Implementierung sehr günstige Gewichtungskoeffizientensätze, die möglichst viele Gewichtungskoeffizienten aufweisen, die Null sind. Dem etwas erhöhten Aufwand an Rechenleistung für das Entwurfsverfahren steht so ein besonders aufwandsgünstiger digitaler Filter gegenüber.

Das erfindungsgemäße Filter wird vorzugsweise fest verdrahtet oder computerimplementiert, beispielsweise durch einen programmierten digitalen Signalprozessor realisiert. Das erfindungsgemäße Verfahren zur Bestimmung der Filterkoeffizienten wird bevorzugt als Computerprogramm realisiert und auf einem Speichermedium, beispielsweise einer Diskette, abgespeichert. Dieses Computerprogrammprodukt veranlasst dann einen programmierbaren Rechner zur Durchführung des Bestimmungsverfahrens.

Weitere vorteilhafte Ausgestaltungen und Weiterbildungen der Erfindung sind Gegenstand der Unteransprüche sowie der folgenden Beschreibung bevorzugter Ausführungbeispiele.

Im Folgenden wird die Erfindung anhand von Ausführungsbeispielen unter Bezugnahme auf die beigelegten Figuren näher erläutert. Es zeigt dabei:

Figur 1:     ein erfindungsgemäßes Interpolationsfilter;

Figur 2:     ein erfindungsgemäßes Integrations- und Löschfilter erster und zweiter Ordnung;

Figur 3:     eine zweite Ausführungsform des erfindungsgemäßen Interpolationsfilters;

Figur 4:     eine dritte Ausführungsform des erfindungsgemäßen Interpolationsfilters;

Figur 5:     eine vierte Ausführungsform des erfindungsgemäßen Interpolationsfilters;

Figur 6:     eine alternative Ausführungsform einer erfindungsgemäßen Integratorstufe;

Figur 7:     ein erfindungsgemäßes Dezimationsfilter;

Figur 8:     eine zweite Ausführungsform des erfindungsgemäßen Dezimationsfilters;

Figur 9:     eine segmentierte Zielimpulsantwortfunktion;

Figur 10:     Kurven maximaler Fehler durch erfindungsgemäße Filter realisierte Impulsantwortfunktionen;

Figur 11:     Frequenzgang der erfindungsgemäßen Filter gegenüber den Zielfilterfunktionen;

Figur 12:     eine erfindungsgemäß realisierte Impulsantwortfunktion;

Figur 13:     Frequenzgänge von Zielfilterfunktionen und erfindungsgemäß realisierten Impulsantwortfunktionen;

Figur 14:     eine symmetrisierte Zielimpulsantwortfunktion;

Figur 15:     eine symmetrische Ausführung des erfindungsgemäßen Interpolationsfilters;

Figur 16:     eine alternative Ausführungsform des erfindungsgemäßen symmetrischen Interpolationsfilters;

Figur 17:     eine symmetrische Ausführung des erfindungsgemäßen Dezimationsfilters;

Figur 18:     eine Polyphasen-Ausführung des erfindungsgemäßen Interpolationsfilters;

Figur 19:     eine Polyphasen-Ausführung des erfindungsgemäßen Dezimationsfilters;

Figur 20:  ein Ausführungsbeispiel für ein verbessertes erfindungsgemäßes Polyphasen-Interpolationsfilters;

Figur 21:  eine Ausführungsform eines verbesserten erfindungsgemäßes Polyphasen-Dezimationsfilters;

Figur 22:  Impulsantwortfunktionen und Frequenzgänge der erfindungsgemäßen Polyphasenfilter;

Figur 23:  eine Comb-Filterimpulsantwortfunktion; und

Figur 24:  eine Weiterbildung mit Verschiebeeinrichtungen eines erfindungsgemäßen Interpolationsfilters.

In den Figuren sind, sofern nichts anderes angegeben ist, gleiche bzw. funktionsgleiche Elemente mit denselben Bezugsziffern versehen worden.

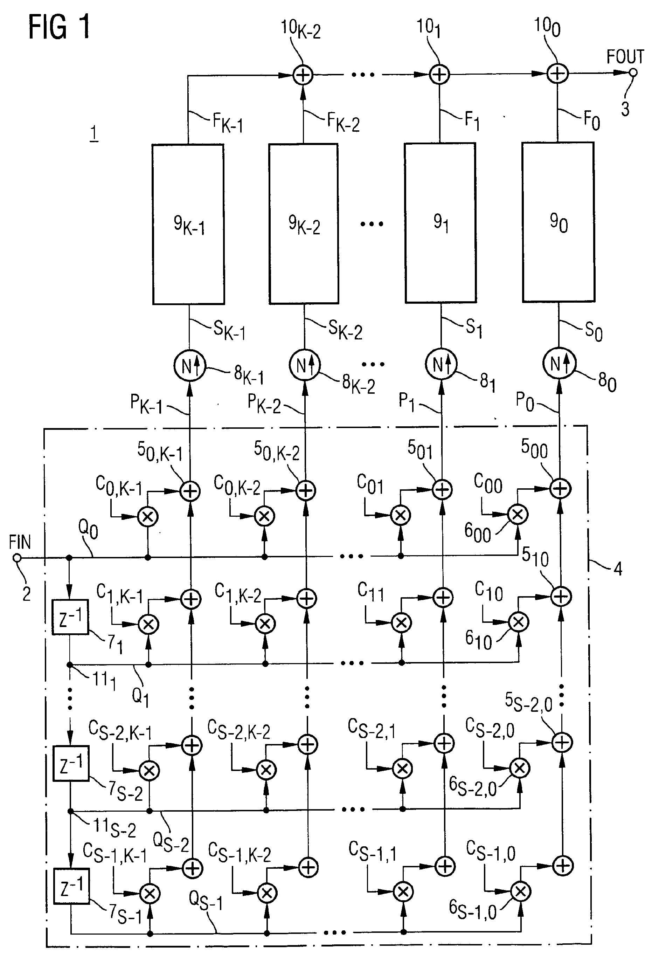

In der Figur 1 ist ein als Interpolationsfilter ausgeführtes erfindungsgemäßes digitales Filter 1 in allgemeiner Form dargestellt.

Das digitale Filter 1 weist einen Eingang 2 zum Entgegennehmen eines digitalen Eingangsignals FIN und einen Ausgang 3 zum Ausgeben eines gefilterten digitalen Ausgangssignals FOUT auf. An den Eingang 2 ist ein Gewichtungsnetzwerk 4 gekoppelt, das eine Matrix von Addierern $5_{ij}$ und Multiplizierern $6_{ij}$ aufweist, wobei den Multiplizierern jeweils Gewichtungskoeffizienten $C_{ij}$ zugeführt sind, i = 0 bis S - 1 und j = 0 bis K - 1 läuft. K entspricht dabei der Filterordnung des Interpolationsfilters 1, und S bezeichnet die Anzahl von Segmenten, in die eine zuvor gewählte Zielimpulsantwortfunktion des Filters zerlegt wurde. Die Zerlegung in Segmente und die Realisierung durch das erfindungsgemäße Filter 1 wird im Folgenden näher erläutert.

Das Gewichtungsnetzwerk 4 sieht ferner eine Kette von Verzögerungsgliedern $7_i$ mit i = 1 bis S - 1 vor, welche an den Eingang 2 gekoppelt ist. Das Gewichtungsnetzwerk 4 liefert Vorladesignale $P_j$ mit j = 0 bis K - 1 an Abtast- bzw. Auftasteinrichtungen $8_j$, wobei die Auftasteinrichtungen $8_j$ Abtastsignale $F_j$ erzeugen, welche an Filtereinheiten $9_j$ geführt sind. Jede Filtereinheit $9_j$ liefert ein Ausgangssignal $F_j$, welches über Addierer $10_j$ zu dem Ausgangssignal FOUT summiert wird.

Die Filtereinheiten $9_j$ weisen jeweils eine Filterfunktion vorgegebener rekursiver Filterordnung auf, wobei die Filtereinheit $9_0$ erster Ordnung, die Filtereinheit $9_1$ zweiter Ordnung ist usw. bis zur Filtereinheit $9_{K-1}$, welche eine Filterfunktion K-ter Ordnung aufweist.

Das Gewichtungsnetzwerk 4 wird hier mit einer ersten niedrigen Taktrate betrieben und die Filtereinheiten $9_j$ mit einer zweiten höheren Taktrate. Aus dem Eingangssignal FIN werden durch die seriell verschalteten Verzögerungsglieder $7_i$ interne verzögerte Signale $Q_i$ mit i = 0 bis S - 1 erzeugt und sind an Leitungsknoten $11_i$. Das nullte interne verzögerte Signal $Q_0$ entspricht dem Eingangssignal FIN und das letzte interne verzögerte Signal $Q_{S-1}$ ist an dem Ausgang des letzten Verzögerungsgliedes $7_{S-1}$ abgreifbar.

Das Gewichtungsnetzwerk 4 ist so ausgestaltet, dass die Vorladesignale $P_j$ Linearkombinationen der verzögerten internen Signale $Q_i$ entsprechen, wobei die Koeffizienten einer jeweiligen Linearkombination aus den Gewichtungskoeffizienten $C_{i,j}$ einer Spalte der hier in Figur 1 matrixförmig dargestellten Gewichtungskoeffizienten entsprechen. Bei jedem N-ten Takt liefert die jeweilige Abtasteinrichtung 8j das entsprechende Vorladesignal $P_j$ als Abtastsignal $S_j$ an die jeweilige Filtereinheit $9_j$ und sonst Nullen. Die Filtereinheiten $9_j$ weisen jeweils eine Impulsantwortfunktion $H_j(z)$ auf. Als günstige Wahl für die Filtereinheiten $9_j$ haben sich sogenannte Integrations- und Löschfilter erwiesen.

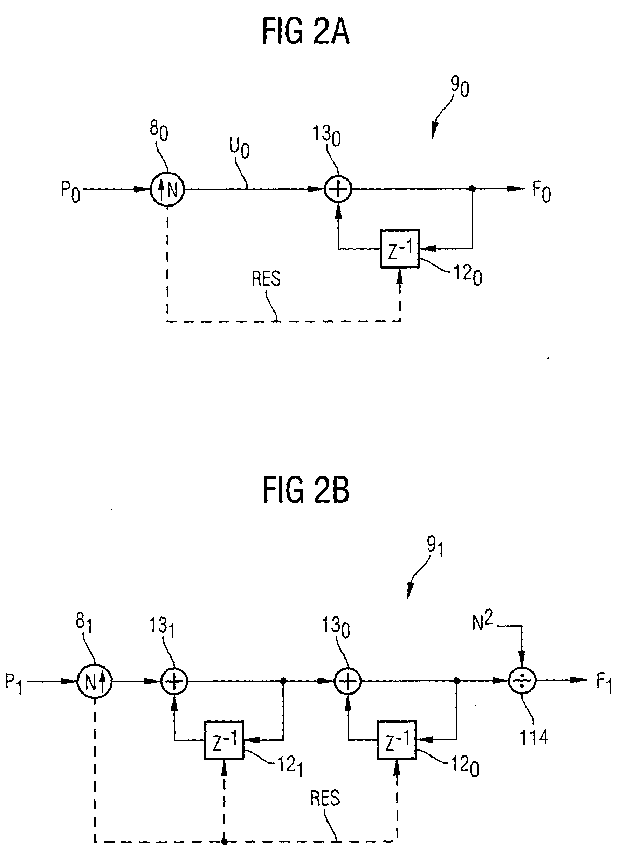

In der Figur 2 (A) ist ein Integrations- und Löschfilter erster Ordnung dargestellt. In dem Signalpfad ist ein mittels eines Addierers $13_0$ rückgekoppeltes Verzögerungsglied $12_0$ vorgesehen. Die Abtasteinrichtung $8_0$ ist hier als Auftasteinrichtung mit einem Auftastfaktor N vorgesehen. Das Eingangssignal $P_0$, welches mit einer niedrigen Abtastrate anliegt, wird von der Abtasteinrichtung $8_0$ aufgetastet, sodass ein aufgetastetes Signal $U_0$ erzeugt wird, welches einen Abgriff bzw. eine Stützstelle mit dem Wert des anliegenden Eingangssignals $P_0$ aufweist und N-1 Abgriffe mit dem Wert 0 aufweist. Der aus dem Addierer $13_0$ und dem Verzögerungsglied $12_0$ bestehende Integrierer integriert diese Signalfolge und liefert als Ausgangssignal F0 N Mal den Wert des Eingangssignals $P_0$ jedoch mit N-fachen Abtastrate bzw. mit der N-fachen Anzahl von Abgriffen oder Stützstellen. Nach N Abgriffen setzt die Abtasteinrichtung $8_0$ das Verzögerungsglied $12_0$ zurück bzw. auf Null. Die entsprechende Filterfunktion eines derartigen als Integrations- und Löschfilters erster Ordnung bezeichneten Filters lautet:

$$H_1^{DI}(z) = \frac{1 - z^{-N}}{1 - z^{-1}} .$$

Dabei steht die Bezeichnung DI für "dump integrator", was im Folgenden synonym für "integrate and dump filter", also Integrier- und Löschfilter oder Integrations- und Löschfilter verwendet wird.

Die Figur 2 (B) zeigt ein entsprechendes Integrations- und Löschfilter zweiter Ordnung, das durch Kaskadierung zweier Integrations- und Löschstufen, wie sie in der Figur 2 (A) dargestellt ist, realisiert wurde. Im Signalpfad sind zwei jeweils aus Addierer $13_0$, $13_1$ und rückgekoppelten Verzögerungsgliedern $12_0$, $12_1$ bestehende Integrations- und Lösch-filter dargestellt, wobei die Auftasteinrichtung $8_1$ jeweils ein Rücksetzsignal an die Verzögerungsglieder $12_0$, $12_1$ liefert. Ausgangsseitig ist ferner ein Dividierer 114 vorgesehen, der mit einem Normalisierungsfaktor $N^2$ dividiert. Die Filter-funktion eines entsprechenden Integrations- und Löschfilters zweiter Ordnung lautet:

$$\text{(Gl. 1)} \qquad H_2^{DI}(z) = \frac{1 - z^{-N}}{\left(1 - z^{-1}\right)^2} - N\frac{z^{-N}}{1 - z^{-1}}.$$

Allgemein lässt sich die Filterfunktion eines Integrations- und Löschfilters k-ter Ordnung, d.h. mit k seriell verschalteten Integrationsstufen wie sie in der Figur 2 dargestellt sind, wie folgt ausdrücken:

$$\text{(Gl. 2)} \qquad H_{DI}^{k,N}(z) = \sum_{n=0}^{N-1} \binom{n + k - 1}{K - 1} z^{-n}.$$

Für ein Integrations- und Löschfilter dritter Ordnung mit einem Abtastratenumsetzfaktor von N = 8 ergibt sich so eine Impulsantwortfunktion:

$$\text{(Gl. 3)} \qquad H_{DI}^{K=3,N=8}(z) = 1 + 3z^{-1} + 6z^{-2} + 10z^{-3} + 15z^{-4} + 21z^{-5} + 28z^{-6} + 36z^{-7}.$$

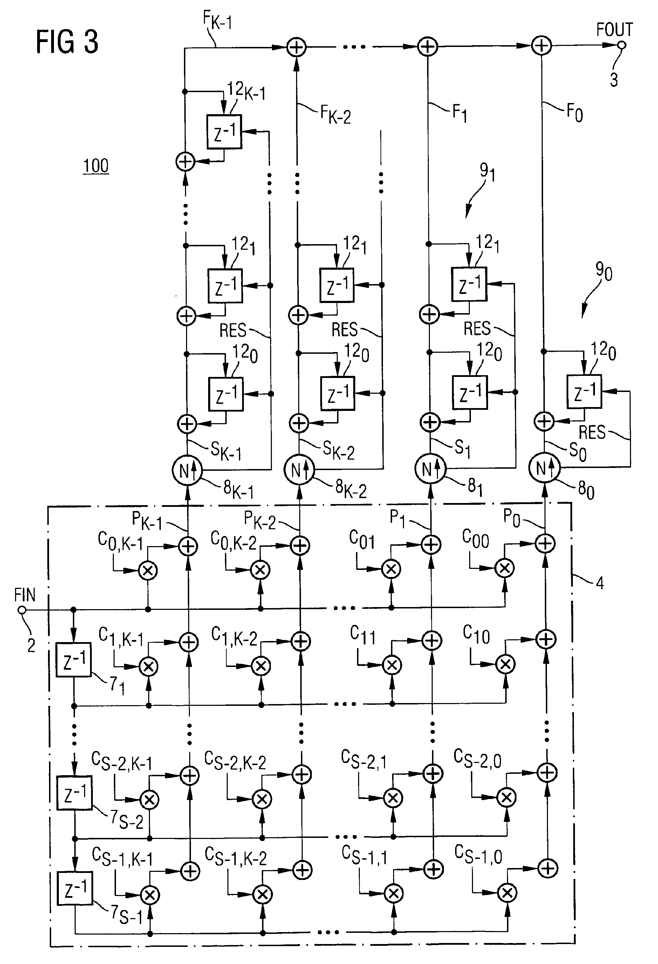

In der Figur 3 ist der Einsatz derartiger Integrations- und Löschfilterketten als Filtereinheit $9_j$ mit j = 0 bis K - 1 dargestellt. Die Struktur des Interpolationsfilters 100 entspricht im Wesentlichen der Darstellung aus Figur 1. Die jewei-ligen Abtasteinrichtungen $8_j$ mit j = 0 bis K - 1 setzen zu jedem N-ten Takt der höheren Taktrate, mit der das Gewichtungsnetzwerk 4 betrieben ist, die in Serie verschalteten Verzögerungsglieder $12_j$ mit j = 0 bis K - 1 zurück. Die als das Ausgangssignal $F_{OUT}$ des Filters zusammengeführten Ausgangssignale $F_j$ mit j = 0 bis K - 1 der Filtereinheiten $9_j$ lassen sich darstellen als:

$$\text{(Gl. 4)} \quad H_{Tree}^{K,N}(z) = \left\{ P_0(z) + \left[ P_1(z) + \left( \ldots + P_{K-1}(z) * \frac{1}{1 - z^{-1}} \right) * \frac{1}{1 - z^{-1}} \right] * \frac{1}{1 - z^{-1}} \right\} * \frac{1}{1 - z^{-1}}.$$

Die Gleichung 4 gilt, solange kein Zurücksetzen durch die Rücksetzsignale RES erfolgt. Die Rücksetzsignale setzen die Inhalte der Verzögerungsglieder bzw. Speicherelemente zu Null, unabhängig von dem Wert der Abtastsignale $S_j$. Die Auftaster liefern in den Signalpfad lediglich dann Werte ungleich von Null, nämlich dem Vorladesignal $P_j$ ent-sprechend, wenn ein Rücksetzen der Verzögerungsglieder vollzogen wird. Daher können auch vorteilhafterweise die Verzögerungsglieder zu jedem Rücksetzzeitpunkt mit dem Wert des jeweiligen Vorladesignals gesetzt werden.

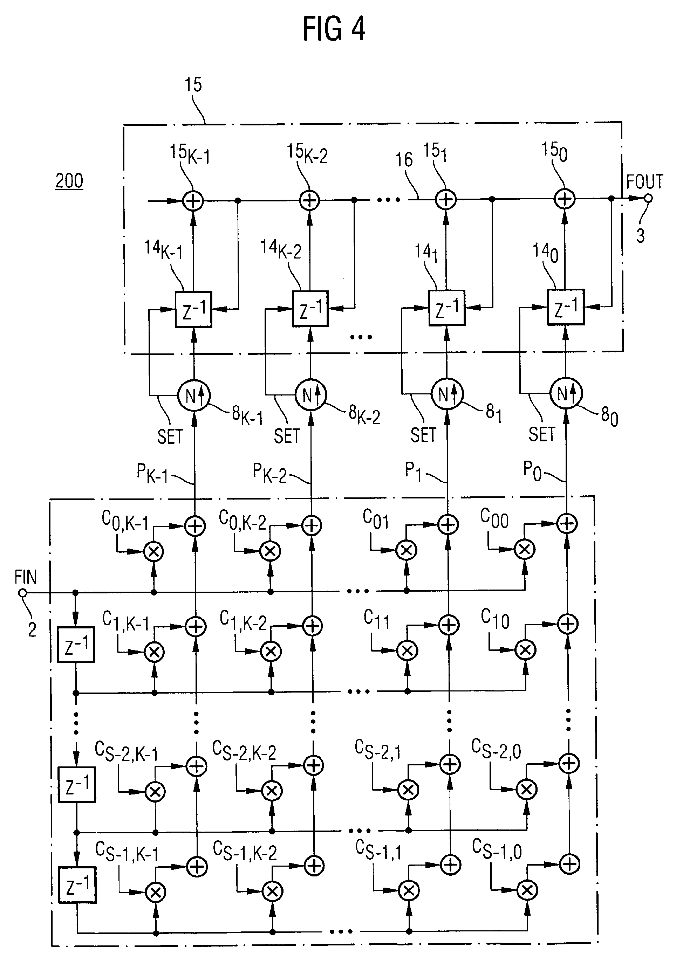

Ferner ergibt sich aus der Gleichung 4, dass die Einzelketten der seriell verschalteten Verzögerungsglieder $12_j$ zu einer Integratorstufe zusammengefasst werden kann, welche die K Filtereinheiten ersetzt. Eine entsprechende Ausführung des erfindungsgemäßen Interpolationsfilters auf Basis von Integrations- und Löschfiltern ist in der Figur 4 dargestellt.

Das Gewichtungsnetzwerk 4 entspricht dem in der Figur 1 bzw. 3 dargestellten Ausführungsbeispiel. Die Integratoreinheit 15 weist Verzögerungsglieder $14_j$ auf, die an die jeweiligen Auftasteinrichtungen $8_j$ gekoppelt sind. Zu jedem N-ten Takt der höheren Taktrate, mit dem die Abtasteinrichtungen $8_j$ und die Integratorstufe 15 betrieben sind, setzt eine jeweilige Auftasteinrichtung $8_j$ den Wert des anliegenden Vorladesignals $P_j$ in die zugeordnete Verzögerungs-

einrichtung $14_j$. Die Verzögerungseinrichtungen $14_j$ sind über Addierer $15_j$ jeweils rückgekoppelt und bilden in einem Ausgangssignalzweig 16 gemeinsam das Ausgangssignal FOUT.

Jede rückgekoppelte Verzögerungseinrichtung $14_j$ der Integratorstufe 15 liefert dabei einen Beitrag zur rekursiven Ordnung des Filters, wobei zwischen dem Eingang 2 des Filters und dem Ausgang 3 des Filters jedes Verzögerungsglied $14_j$ einer Filterordnung zugeordnet werden kann. Beispielsweise liefert das Verzögerungsglied $14_0$ jeweils Beiträge von erster rekursiver Ordnung für das Ausgangssignal FOUT.

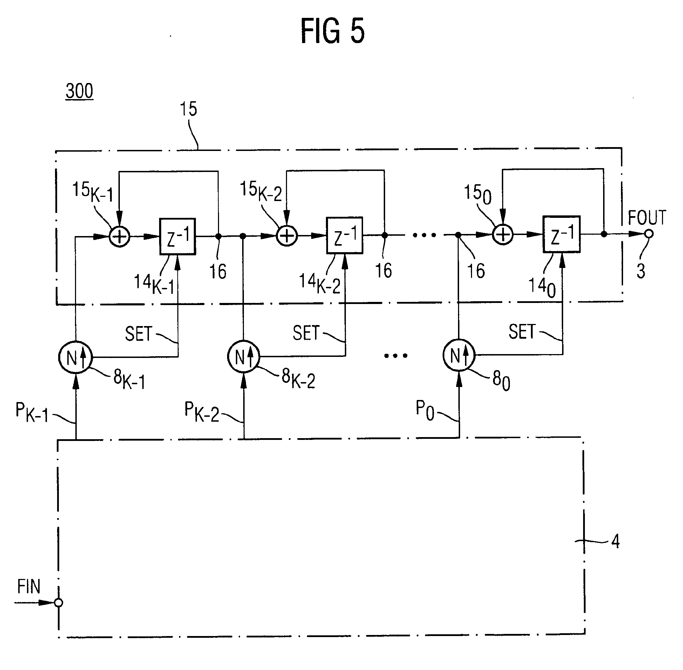

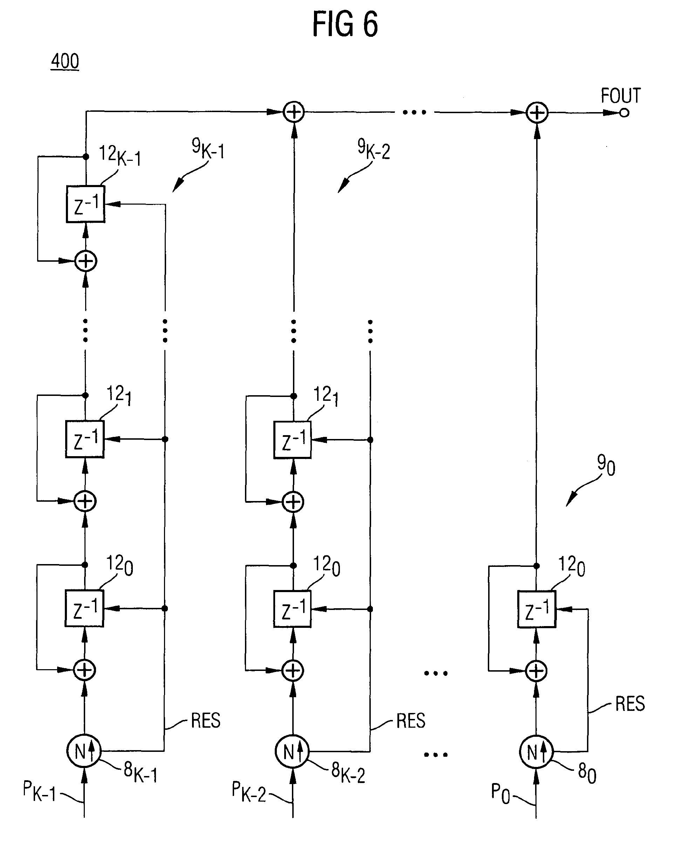

Die in der Integratorstufe 15 vorgehaltenen Verzögerungsglieder $14_j$ können auch alternativ seriell als eine Kette von rückgekoppelten Verzögerungsgliedern ausgestaltet sein. Die Figur 5 zeigt eine entsprechende Ausführungsform des erfindungsgemäßen Interpolationsfilters 300. Hier sind die Verzögerungsglieder $14_j$ jeweils rückgekoppelt und in Serie zwischen dem Ausgang 3 des Filters und der k-ten Auftasteinrichtung $8_k$ verschaltet, wobei jeweils am Leitungsknoten 16 zwischen den rückgekoppelten Verzögerungsgliedern $14_j$ die Auftasteinrichtungen $8_j$ angekoppelt sind. Die jeweiligen als Integratoren rückgekoppelten verschalteten Verzögerungsglieder $15_j$ weisen hier eine Impulsantwort proportional zu $H(z) = z^{-1}/(1-z^{-1})$ auf. Auch die in den Figuren 2 und 3 dargestellten Ketten von rückgekoppelten Verzögerungsgliedern der einzelnen Filtereinheiten $9_j$ können in dieser Form realisiert werden. Die Figur 6 zeigt eine entsprechende alternative Ausführungsform 400 der Filtereinheiten $9_j$.

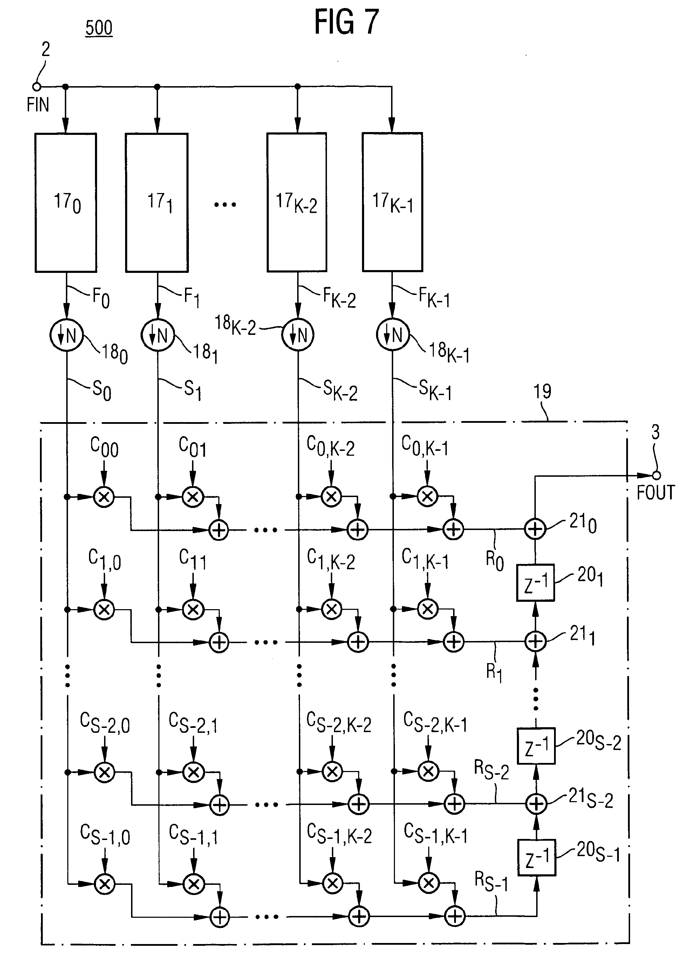

Analog zur Figur 1 lässt sich erfindungsgemäß ebenso ein Dezimationsfilter erfindungsgemäß aufbauen, wie es beispielsweise in Figur 7 dargestellt ist. Das erfindungsgemäße Dezimationsfilter 500 weist einen Eingang 2 und einen Ausgang 3 auf, wobei an dem Eingang 2 ein Eingangssignal FIN mit hoher Abtastrate anliegt und an dem Ausgang 3 ein gefiltertes Ausgangssignal FOUT mit niedrigerer Abtastrate abgreifbar ist. Das Eingangssignal FIN wird jeweils den Filtereinheiten $17_j$ mit j = 0 bis K - 1 zugeführt, die jeweils Ausgangssignale $F_j$ an eine jeweils zugeordnete Abtasteinrichtung $18_j$ ausgeben.

Die Filtereinheiten 17j realisieren wie zu der Figur 1 erläutert jeweils eine vorgegebene rekursive Filterordnung. Vorzugsweise sind die jeweiligen Filterfunktionen unabhängig und orthogonal zueinander. Somit können die jeweiligen Impulsantwortfunktionen der Filtereinheiten als Basisfunktion für die Realisierung einer Zielimpulsantwortfunktion dienen. Die Abtasteinrichtungen $18_j$ liefern jeweils Abtastsignale $S_j$ an ein Gewichtungsnetzwerk 19.

Das...Gewichtungsnetzwerk 19 liefert Segmentsignale $R_i$ mit i = 0 bis S-1, wobei ein jeweiliges Segmentsignal einer Linearkombination aus den Abtastsignalen $S_j$ darstellt. Die jeweiligen Koeffizienten der Linearkombinationen entsprechen den Gewichtungskoeffizienten $C_{ij}$. An dem Ausgang 3 des Filters ist eine Kette von Verzögerungsgliedern $20_i$ mit i = 1 bis S - 1 geschaltet. Die Segmentsignale $R_i$ mit i = 1 bis S - 2 werden über Addierer $21_i$ mit i = 1 bis S - 2, welche zwischen den Verzögerungsgliedern $20_i$ vorgesehen sind, in die Verzögerungsglieder $20_i$ eingekoppelt. Dabei wird das nullte Segmentsignal $R_0$ direkt über einen Addierer $21_0$ an den Ausgang 3 des Dezimationsfilters gekoppelt, und das s-te Segmentsignal $R_{S-1}$ wird direkt an einen Eingang des letzten, s-ten Verzögerungsgliedes $20_{s-1}$ eingekoppelt. Ähnlich der Ausführungsformen als Interpolationsfilter gemäß der Figuren 1 bis 6 wird daher ein niedrig abtastratiges Ausgangssignal FOUT aus Segmenten zusammengestellt.

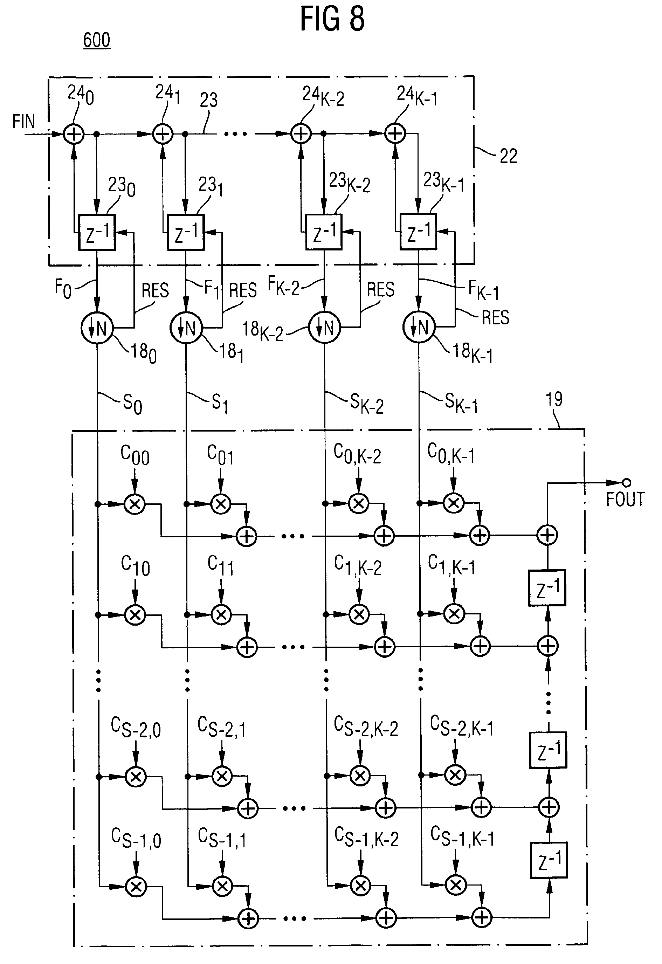

Ein bevorzugtes Ausführungsbeispiel eines erfindungsgemäßen Dezimationsfilters ist in der Figur 8 dargestellt. Bei dem Dezimationsfilter 600 sind die Filtereinheiten zu einer Integratorstufe 22 zusammengefasst. Die Integratorstufe 22 hat ähnlich, wie der in Figur 4 des Interpolationsfilters dargestellt ist, in einem Eingangssignalzweig 23, jeweils über Addierer $24_j$ zurückgekoppelte Verzögerungsglieder $23_j$ mit j = 0 bis K - 1. Die jeweiligen rückgekoppelten Verzögerungsglieder $23_j$ liefern jeweils Signale $F_j$ an die Abtasteinrichtungen $18_j$. Die Abtasteinrichtungen $18_j$ setzen bei einem Dezimationsfaktor N jeweils bei einem N-ten Abgriff das jeweilige zugeordnete Verzögerungsglied $23_j$ auf 0 zurück.

Die Bestimmung der Gewichtungskoeffizienten $C_{ij}$ bestimmt hauptsächlich die jeweilige Filterübertragungsfunktion oder Impulsantwortfunktion des Filters zur Abtastratenumsetzung. Dabei sind die jeweiligen Gewichtungskoeffizienten zur Realisierung einer Zielimpulsantwortfunktion dieselben für das Interpolations- oder Dezimationsfilter. Die in den Figuren 1 bis 8 dargestellten Varianten für die Filtereinheiten bzw. Integratoreinrichtungen bedingen prinzipiell jeweils unterschiedliche Matrizen von Gewichtungskoeffizienten. Die Bestimmung dieser Matrix erfolgt jedoch jeweils nach demselben Verfahren. Im Prinzip wird dabei eine gewählte Zielimpulsantwortfunktion segmentweise durch eine Linearkombination der verzögerten Impulsantwortfunktionen der Filtereinheiten aufgebaut. Dies ist im Folgenden näher erläutert. Beispielhaft werden für die Filterfunktionen der Filtereinheiten bzw. der Abgriffe der Filterketten der Integratorstufe im Folgenden Funktionen gemäß Gl. 2 angenommen.

Die durch ein erfindungsgemäßes Filter, wie es in den Figuren 1 bis 8 dargestellt ist und eine verallgemeinerte Form von Integrations- und Löschfiltern darstellt, realisierte Impulsantwortfunktion $H^{n,k}_{GIAD}(z)$ hängt nun im Wesentlichen von der Wahl der Gewichtungskoeffizienten $C_{i,j}$ ab. Die Impulsantwortfunktion kann wie folgt dargestellt werden:

$$(Gl. 5) \qquad H_{GIAD}^{N,K}(z) = \frac{1}{N^K} \cdot \underline{H} \cdot \underline{C} \cdot \underline{D}$$

$$\underline{H} = \begin{pmatrix} H_1^{DI}(z) & H_2^{DI}(z) & \dots & H_K^{DI}(z) \end{pmatrix}$$

$$\underline{C} = \begin{pmatrix} C_{0,0} & C_{0,1} & \dots & C_{0,K-1} \\ C_{1,0} & C_{1,1} & \dots & C_{1,K-1} \\ \vdots & \vdots & \ddots & \vdots \\ C_{S-1,0} & C_{S-1,1} & \dots & C_{S-1,K-1} \end{pmatrix}$$

$$\underline{D} = \begin{pmatrix} 1 & z^{-N} & z^{-2N} & \dots & z^{-(S-1)N} \end{pmatrix}$$

Dabei enthält der Vektor $\underline{H}$ die z-Transformationen der Filtereinheiten bzw. hier der Integrations- und Löschfilter, $\underline{C}$ entspricht der Matrix der Gewichtungskoeffizienten $C_{ij}$ und der Vektor $\underline{D}$ stellt die Kette von Verzögerungsgliedern $7_i$ mit i = 0 bis s - 1 des Gewichtungsnetzwerkes 4 dar. Die Abtastrate der Signale ist auf die hohe Taktfrequenz bezogen, weshalb die Verzögerungen $\underline{D}$ mit dem Interpolationsfaktor N potenziert sind. Die Gleichung 5 beschreibt eine Impulsantwortfunktion $H^{N,K}{}_{GIAD}(z)$, die die S-Segmente jeweils der Länge N überdeckt. Dabei bezeichnet GIAD (= generalised itegrate and dump), also das erfindungsgemäße, verallgemeinerte Integrations- und Löschfilter. Jedes Segment s erzeugt eine Impulsantwort eines Integrations- und Löschfilters der Länge N, wobei jedes Segment eine Verzögerung um N Abgriffe bzw. Stützstellen aufweist. Eine jeweilige Segmentlänge ist daher von dem Interpolations- oder Dezimationsfaktor bzw. Abtastratenumsetzfaktor N abhängig. Es ist nun möglich, eine beliebige Zielimpulsantwortfunktion für einen Umsetzfaktor N anzugeben und die Koeffizientenmatrix in Gleichung 5 derart anzupassen, dass die resultierende Impulsantwortfunktion $H^{N,K}{}_{GIAD}(z)$ diese Zielimpulsantwortfunktion möglichst gut approximiert.

Bei einer gewünschten Zielimpulsantwortfunktion in Form einer Comb-Filterfunktion

$$(Gl. 6) \qquad H_{CF}^{N,K}(z) = \frac{1}{N^K} \left( \frac{1-z^{-N}}{1-z^{-1}} \right)^K = \frac{1}{N^K} \bigotimes_{k=0}^{K-1} \left\{ \sum_{n=0}^{N-1} z^{-n} \right\}$$

ist beispielsweise eine exakte Berechnung der Gewichtungskoeffizienten $C_{ij}$ möglich. Dabei ist N der Abtastratenumsetzfaktor und K die maximale rekursive Ordnung des gewünschten Filters. Die Länge eines Segments beträgt daher N, wobei die Länge der Zielimpulsantwortfunktion für ein Comb-Filter $L_{CF}^{N,K} = K \cdot N - K + 1 = K(N-1)+1$ beträgt. Für praktische Anwendungen gilt in der Regel K < N - 1, sodass eine quadratische Matrix von Gewichtungskoeffizienten mit S = K gewählt werden kann, hier also S = $S_{CF}^{N,K}$ = N. Für jedes Segment s ergibt sich so ein Gleichungssystem

$$(Gl. 7)$$

$$\begin{pmatrix} h_{s \cdot N - 0}^{CF} \\ h_{s \cdot N + 1}^{CF} \\ \vdots \\ h_{s \cdot N - N - 1}^{CF} \end{pmatrix} = \underbrace{\begin{pmatrix} w_{0,1} & w_{0,2} & \cdots & w_{0,K} \\ w_{1,1} & w_{1,2} & \cdots & w_{1,K} \\ \vdots & \vdots & \ddots & \vdots \\ w_{N-1,1} & w_{N-1,2} & \cdots & w_{N-1,K} \end{pmatrix}}_{\underline{w}} \cdot \underbrace{\begin{pmatrix} C_{s,0} \\ C_{s,1} \\ \vdots \\ C_{s,K-1} \end{pmatrix}}_{\underline{C}(s,:)^T} \qquad \forall s \in \mathbb{N}, 0 \leq s < S_{CF}^{N,K}.$$

Der Vektor auf der linken Seite der Gleichung 10 bezeichnet die Werte der Zielimpulsantwortfunktion, hier der entsprechenden Comb-Filterfunktion, an den Stützstellen S N + i, wobei S Segmente numeriert und i die Stützstellen in dem Segment. Die Aufbauimpulsantwortmatrix $\underline{w}$ hängt nicht von dem jeweiligen Segment ab, da die Impulsantwortfunktionen der Integrations- und Löschfilter zueinander orthogonal sind. Das jeweilige Gewicht w lässt sich aus der allgemeinen Gleichung für die Impulsantwortfunktionen der Integrations- und Löschfilter (Gleichung 2) bestimmen:

$$\text{(Gl. 8)} \qquad w_{n,K} = \binom{n + K - 1}{K - 1}.$$

Für jedes Segment ergibt sich damit ein Gleichungssystem gemäß der Gleichung 7. Wird beispielsweise ein Abtastratenumsetzfaktor N = 8 angenommen und die Zielimpulsantwortfunktion eines Combfilters dritter Ordnung verwendet, ergeben sich für die Stützstellen folgende Werte:

$$\text{(Gl. 9)} \qquad h = [1, \ 3, \ 6, \ 10, \ 15, \ 21, \ 28, \ 36, \ 42, \ 46, \ 48, \ 48,$$
$$46, \ 42, \ 36, \ 28, \ 21, \ 15, \ 10, \ 6, \ 3, \ 1, \ 0, \ 0].$$

Die ersten acht Werte entsprechen damit dem Segment für S = 0, woraus sich die in dem hier gewählten Beispiel drei Gewichtungskoeffizienten $C_{00}$, $C_{01}$, $C_{02}$ bestimmen lassen. Aus den zweiten acht Stützstellen wird $C_{10}$, $C_{11}$, $C_{12}$ bestimmt und aus den letzten acht Werten des Vektors h die Gewichtungskoeffizienten $C_{20}$, $C_{21}$, $C_{22}$. Die besondere Wahl der Integrations- und Löschfilter ermöglicht hier die exakte Bestimmung der jeweiligen Gewichtungskoeffizienten, die in einer Matrix zusammengefasst folgende Werte aufweisen:

$$\text{(Gl. 10)} \qquad \underline{C} = \begin{pmatrix} C_{0,0} & C_{0,1} & C_{0,2} \\ C_{1,0} & C_{1,1} & C_{1,2} \\ C_{2,0} & C_{2,1} & C_{2,2} \end{pmatrix} = \begin{pmatrix} 0 & 0 & 1 \\ 36 & 8 & -2 \\ 28 & -8 & 1 \end{pmatrix}.$$

Im Folgenden wird zur Erläuterung des Verfahrens zur Bestimmung der Gewichtungskoeffizienten eine beliebige Zielimpulsantwortfunktion $H_{IAF}(z)$ angenommen. Für eine gegebene maximale Filterordnung K, den Abtastratenumsetzfaktor N und der Länge der Zielimpulsantwortfunktion, also der Anzahl der zu berücksichtigenden Stützstellen, können die Gewichtungskoeffizienten $C_{ij}$ derart bestimmt werden, dass eine durch das erfindungsgemäße Filter realisierte Impulsantwortfunktion im Wesentlichen der Zielimpulsantwortfunktion $H_{IAF}(z)$ entspricht. Dazu werden die Gewichtungskoeffizienten segmentweise bestimmt.

Ausgehend von $H_{IAF}(z)$ ergibt sich wie in Gleichung 7 ein Gleichungssystem:

$$\text{(Gl. 11)}$$

$$\underbrace{\begin{pmatrix} h_{s \cdot N+0} \\ h_{s \cdot N+1} \\ \vdots \\ h_{s \cdot N+N-1} \end{pmatrix}}_{\underline{h}} = \underbrace{\begin{pmatrix} w_{0,1} & w_{0,2} & \cdots & w_{0,K} \\ w_{1,1} & w_{1,2} & \cdots & w_{1,K} \\ \vdots & \vdots & \ddots & \vdots \\ w_{N-1,1} & w_{N-1,2} & \cdots & w_{N-1,K} \end{pmatrix}}_{\underline{w}} \cdot \underbrace{\begin{pmatrix} C_{s,0} \\ C_{s,1} \\ \vdots \\ C_{s,K-1} \end{pmatrix}}_{\underline{c}} \qquad \forall s \in \mathbb{N}, 0 \le s < S_{CF}^{N,K}, w_{n,K} = \binom{n + K - 1}{K - 1},$$

wobei $\underline{h}$ der Stützstellenvektor, $\underline{c}$ der Gewichtungskoeffizientenvektor und $\underline{W}$ die Antwortimpulsmatrix darstellt. Für die hier betrachteten Integrations- und Löschfilter lautet

$$(Gl.\ 12) \qquad w_{n,K} = \begin{pmatrix} n + K - 1 \\ K - 1 \end{pmatrix}.$$

Es wird nun ein Fehlervektor $\underline{e}$ eingeführt, der dieselbe Dimension wie der Stützstellenvektor $\underline{h}$ hat und angibt wie groß eine jeweilige Abweichung des durch $\underline{w}\,C$ erzeugten Filters ist. Somit lautet:

$$(Gl.\ 13) \qquad \underline{h} = \underline{W} \cdot \underline{c} + \underline{e} \qquad \Rightarrow \qquad \underline{e} = \underline{W} \cdot \underline{c} + \underline{h}.$$

Durch Minimierung dieses Fehlervektors $\underline{e}$, beispielsweise durch ein Verfahren der kleinsten Fehlerquadrate, wird die Zielimpulsantwortfunktion $H_{IAF}(z)$ bestmöglich durch das erfindungsgemäße Filter angenähert. Ein möglicher Restfehler oder eine Abweichung der realisierten Filterimpulsantwortfunktion von der Zielimpulsantwortfunktion kann durch $\left\| \underline{e} \right\| = \sqrt{\underline{e}^T \underline{e}}$ angegeben werden.

In der Regel wird die Näherung besser, je höher die Anzahl der Integrationsstufen in den Filtereinheiten bzw. der Integratoreinrichtung ist. Durch Vorgabe einer Toleranzschwelle für die maximale Abweichung bzw. durch Vorgabe eines Maßes für die minimale Güte der Näherung an die Zielimpulsantwortfunktion $H_{IAF}(z)$ kann die jeweils notwendige Filterordnung bestimmt werden.

Im Folgenden sei als Beispiel für eine beliebige Zielimpulsantwortfunktion eine IIR-Butterworth-Filterimpulsantwort zweiter Ordnung mit einer auf 3 dB normalisierten Eckfrequenz $\omega_n = 0{,}25$ gewählt. Die entsprechende Impulsantwortfunktion für ein derartiges Butterworth-Filter lautet:

$$(Gl.\ 14)$$

$$H_{but2iir}(z) = \frac{b_0 + b_1 z^{-1} + b_2 z^{-2}}{1 + a_1 z^{-1} + a_2 z^{-2}} = \frac{0.09763 + 0.1952 z^{-1} + 0.0976 z^{-2}}{1 - 0.94281 z^{-1} + 0.33 z^{-2}}.$$

Ein erfindungsgemäßes Filter kann diese Butterworth-Filterfunktion nicht vollständig annähern, da keine Realisierung von Infinite Impulse Response-Funktionen möglich ist. Daher wird in dem hier gewählten Beispiel die Zielimpulsantwort nach 16 Abgriffen abgeschnitten. Bei einem Dezimationsfaktor von beispielsweise $N = 4$ ergeben sich so $S = 4$ Segmente, in denen jeweils die Zielimpulsantwortfunktion $h_{but2iir} \approx h_{but2fir}(z)$ durch die Impulsantwortfunktionen der Filtereinheiten der jeweiligen Ordnung angenähert werden.

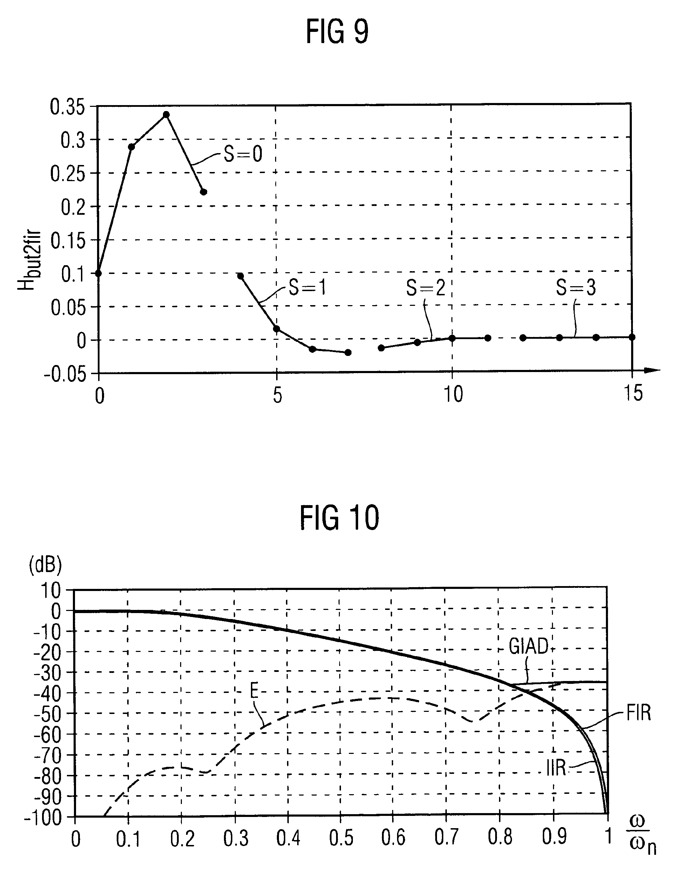

Die Figur 9 zeigt eine derartige als $H_{but2fir}$ bezeichnete Zielimpulsantwortfunktion mit 16 Abgriffen gemäß der Gleichung 17. Die Segmente sind hiermit $s = 0, 1, 2, 3$ bezeichnet. Ferner wird als maximale rekursive Filterordnung $K = 3$ angenommen. Daraus ergeben sich für die Zielsegmente aus der Gleichung 11 die folgenden Stützstellenvektoren und die Aufbauimpulsantwortmatrix:

(Gl. 15)

$$
\underline{W} = \begin{pmatrix} 1 & 1 & 1 \\ 1 & 2 & 3 \\ 1 & 3 & 6 \\ 1 & 4 & 10 \end{pmatrix} \quad \underline{h}_0 = \begin{pmatrix} 0.0976 \\ 0.2873 \\ 0.3360 \\ 0.2210 \end{pmatrix} \quad \underline{h}_1 = \begin{pmatrix} 0.0964 \\ 0.0172 \\ -0.0159 \\ -0.0207 \end{pmatrix} \quad \underline{h}_2 = \begin{pmatrix} -0.0142 \\ -0.0065 \\ -0.0014 \\ 0.0009 \end{pmatrix} \quad \underline{h}_3 = \begin{pmatrix} 0.0013 \\ 0.0009 \\ 0.0004 \\ 0.0001 \end{pmatrix}.
$$

Daraus ergibt sich für die Gewichtungskoeffizienten:

$$
(Gl.\ 16)\quad \underline{c}_0 = \begin{pmatrix} -0.250033 \\ 0.498865 \\ -0.152331 \end{pmatrix} \quad \underline{c}_1 = \begin{pmatrix} 0.208256 \\ -0.149967 \\ 0.037177 \end{pmatrix} \quad \underline{c}_2 = \begin{pmatrix} -0.024772 \\ 0.013253 \\ -0.002737 \end{pmatrix} \quad \underline{c}_3 = \begin{pmatrix} 0.001711 \\ -0.000439 \\ 0.000014 \end{pmatrix}
$$

Die maximale Abweichung von der Zielimpulsantwortfunktion bzw. die Güte der Näherung lässt sich kompakt schreiben, indem die Vektoren der Gewichtungskoeffizienten $\underline{c}_i$ und die Stützstellenvektoren ebenfalls in einer Matrix angeordnet werden:

$$
(Gl.\ 17)\qquad \underline{C} = \begin{pmatrix} \underline{c}_0 & \underline{c}_1 & \cdots & \underline{c}_{S-1} \end{pmatrix}
$$

$$
\underline{H} = \begin{pmatrix} \underline{h}_0 & \underline{h}_1 & \cdots & \underline{h}_{S-1} \end{pmatrix}
$$

sodass eine N x S-Fehlermatrix $\underline{E}$ darstellbar ist als

$$
(Gl.\ 18)\qquad \underline{H} = \underline{W} \cdot \underline{C} + \underline{E}.
$$

Ein Maß für die maximale Abweichung zwischen der Zielimpulsantwortfunktion und der durch das Filter realisierten Impulsantwortfunktion lässt sich so ausdrücken als:

$$
(Gl.\ 19)\qquad E_{max} = \sum_{s=0}^{S-1} \sum_{n=0}^{N-1} \left| \underline{E}(n,\ s) \right|.
$$

Bei dem hier dargestellten Beispiel der Butterworth-Zielimpulsantwortfunktion ist beispielsweise $E_{max} = -35{,}718$ dB angenommen. Mit K = 3 und N = 4 ergibt sich eine praktisch deckungsgleiche Impulsantwortfunktion, wie sie in der Figur 9 dargestellt ist.

Die Figur 10 zeigt den entsprechenden Fehler E in Abhängigkeit von der auf die Eckfrequenz $W_n$ GN = 0,25 normierten Frequenz W. Dabei gibt die Kurve IIR den Frequenzgang des Filters gemäß Gleichung 14 an, FIR ein nach 16 Abgriffen abgeschnittenes IIR-Filter und die Kurve GIAD den Frequenzgang des erfindungsgemäß ausgeführten Filters. Die Kurve E zeigt die maximale Abweichung von der Zielimpulsantwortfunktion, die hier immer unterhalb von etwa -35 dB liegt.

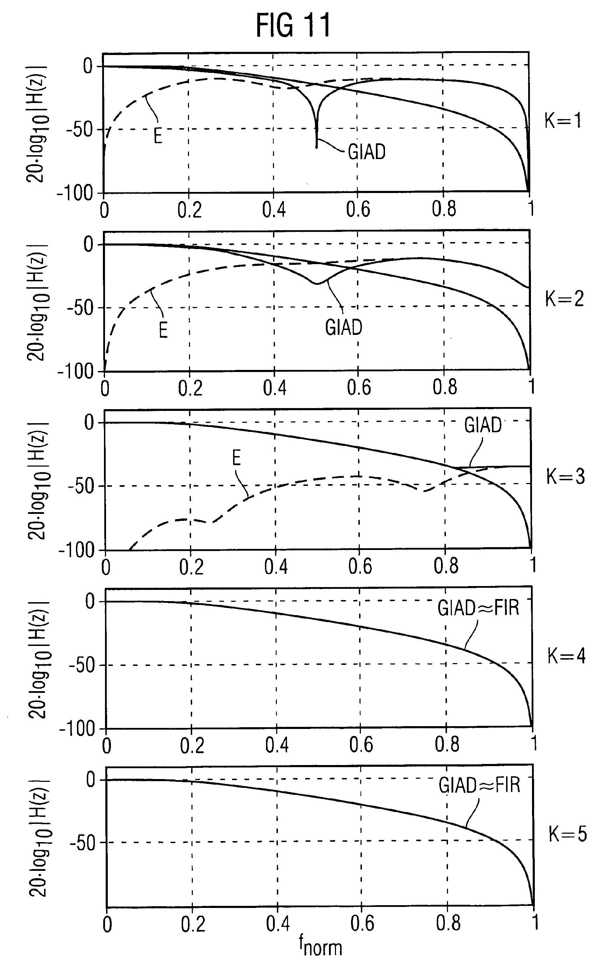

Im Wesentlichen stellt die maximale Ordnung K eine Begrenzung für die mögliche Genauigkeit bzw. Güte der Näherung durch das erfindungsgemäße Filter dar. In der Figur 11 sind ähnliche Fehlerkurven für entsprechende erfindungsgemäße Filter mit K = 1., 2., 3., 4. und 5. Ordnung dargestellt. Ab einer Ordnung von K = 4 liegt der Fehler unterhalb von -100 dB, sodass die Kurve für das erfindungsgemäße Filter praktisch der Zielimpulsantwortfunktion entspricht. Untersuchungen der Anmelderin haben gezeigt, dass üblicherweise eine Ordnung von K ≤ 8 genügt, um ausreichende Genauigkeiten zu erreichen.

Bei einer Erhöhung der maximalen rekursiven Ordnung des erfindungsgemäßen Filters können einige der Gewichtungskoeffizienten besonders klein werden. Durch eine Erhöhung der Ordnung werden in dem Gleichungssystem zur Bestimmung der Gewichtungskoeffizienten (Gl. 11) in der Regel mehr Freiheitsgrade geschaffen, als durch das Gleichungssystem eindeutig bestimmt werden.

Aus einem numerischen Vergleich der Größenordnung der Gewichtungskoeffizienten für K = 4 und K = 5 des vorangegangenen Beispiels der Butterworth-Filter-Approximation ergibt sich, dass bei einer maximalen rekursiven Ordnung von K = 5 die Gewichtungskoeffizienten $C_{s,1}$ praktisch Null sind bzw. derart klein sind, dass sie ohne Verschlechterung der Approximationsgüte des Filters auf Null gesetzt werden können.

Durch eine Überapproximation mittels einer Erhöhung der maximalen rekursiven Ordnung des Filters ergibt sich daher einerseits eine bessere Näherung an die Zielimpulsantwortfunktion, andererseits aber nicht zwingend eine größere Anzahl von nicht verschwindenden Gewichtungskoeffizienten. Mittels dieser Erkenntnisse lässt sich ein verbessertes Bestimmungsverfahren für die Gewichtungskoeffizienten eines erfindungsgemä-ßen digitalen Filters angeben.

Dazu wird als Zielimpulsantwortfunktion eine Combfilterfunktion vierter Ordnung mit gegenüber einem Standard-Combfilter vierter Ordnung verschobenen Nullstellen betrachtet:

$$(\text{Gl. } 20) \qquad H^{\text{smeared}}(z) = \frac{1}{N_1 \cdot N_2 \cdot N^2} \cdot \left( \frac{1 - z^{-N}}{1 - z^{-1}} \right)^2 \cdot \frac{1 - z^{-N_1}}{1 - z^{-1}} \cdot \frac{1 - z^{-N_2}}{1 - z^{-1}} \cdot$$

Als Dezimationsfaktor wird hier N = 16 gewählt, wobei $N_1$ = N - 2 und $N_2$ = N + 2 gewählt wird, während für das Standard-Combfilter $N_1 = N_2 = N$ lautet. Um die Zielfilterfunktion insbesondere in den ersten zwei Alias-Bändern bei Frequenzen $f_{norm}$ = 0,125 und $f_{norm}$ = 0 , 2 5 genau anzunähern, wird für ein erfindungsgemäßes Dezimations- oder Interpolationsfilter eine höchste Ordnung mit K = 6 gewählt. Als vorgegebene Toleranzschwelle für eine Abweichung der durch das erfindungsgemäße Filter realisierten Impulsantwortfunktion von der Zielimpulsantwortfunktion gemäß der Gleichung 19 ist 90 dB gewählt.

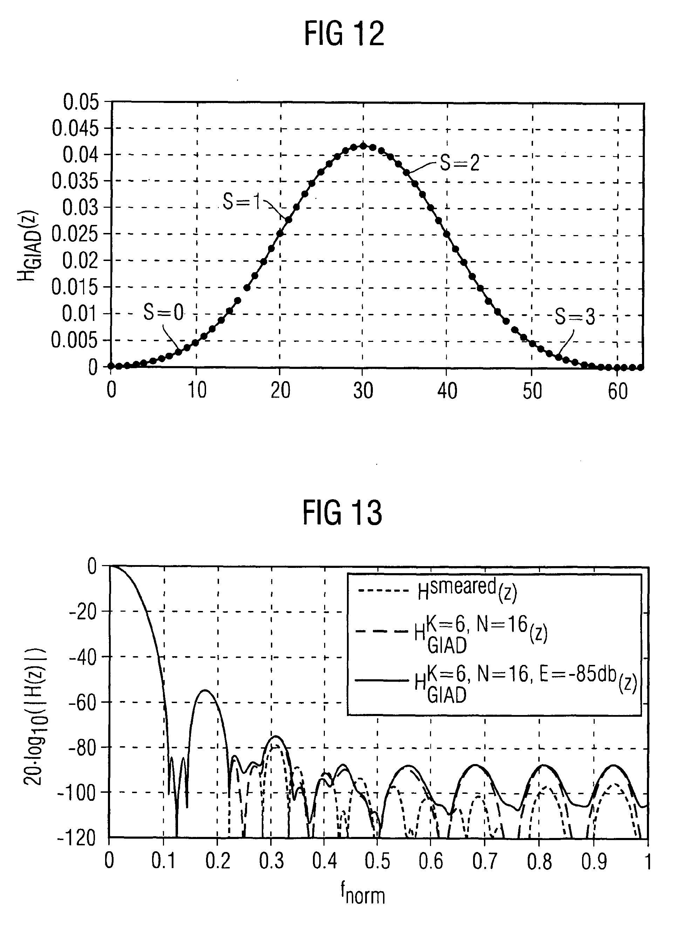

Die Figur 12 zeigt eine erfindungsgemäß realisierte Impulsantwortfunktion mit vier Segmenten, welche durch ein erfindungsgemäßes Filter aus Integrations- und Löschfiltern mit K = 6, N = 16 und S = 3 realisiert ist. Zum Betrieb des Filters sind M = (k + 1) (S + 1) = 6 4 = 24 Multiplikationen mit Gewichtungskoeffizienten in der Basisband-Taktrate erforderlich.

Der Implementierungs- und Rechenaufwand für ein derartiges Filter lässt sich reduzieren, indem Gewichtungskoeffizientensätze gesucht werden, bei denen möglichst viele Gewichtungskoeffizienten $C_{i,j}$ Null sind oder derart kleine Werte aufweisen, dass sie zu Null gesetzt werden können, ohne signifikant die Abweichung der realisierten Filterimpulsantwortfunktionen $H_{GIAD}$ (z) von der Zielimpulsantwortfunktion zu erhöhen. Jeder Gewichtungskoeffizient, der zu Null gesetzt werden kann, reduziert daher den Rechenaufwand bzw. Implementierungsaufwand, da auf die jeweiligen Addierer und Multiplizierer verzichtet werden kann.

Beim Entwurf eines erfindungsgemäßen Filters werden daher zunächst systematisch Gewichtungskoeffizienten in einer Bestimmungsgleichung, wie sie beispielsweise in der Gleichung 11 angegeben ist, zu Null gesetzt und die Optimierung bzw. Interpolation durchgeführt. Bei diesem verbesserten Entwurfsverfahren zur Bestimmung der Filterkoeffizienten bzw. der Gewichtungskoeffizienten werden alle Kombinationen von zu Null gesetzten Koeffizienten $C_{i,j}$ bestimmt und die jeweilige maximale Abweichung der so realisierten Filterimpulsantwortfunktion von der Zielimpulsantwortfunktion berechnet. Anschlie-ßend wird derjenige Gewichtungskoeffizientensatz ausgewählt, der bei einer vorgegebenen Toleranzschwelle für diese Abweichung bzw. Näherungsgüte des erfindungsgemäßen Filters die meisten verschwindenden Gewichtungskoeffizienten aufweist.

Ausgehend von der Gleichung 11 wird zur Realisierung der jeweiligen Randbedingung, dass gewisse Koeffizienten Null sein sollen, eine Maskierungsmatrix <u>M</u> eingefügt:

(Gl. 21)

$$\underline{h} = \underline{M} \cdot \underline{W} \cdot \underline{c} + \underline{e} = \underline{W}^M \cdot \underline{c} + \underline{e}$$

$$\begin{pmatrix} h_{s \cdot N+0} \\ h_{s \cdot N+1} \\ \vdots \\ h_{s \cdot N+N-1} \end{pmatrix} = \begin{pmatrix} m_0 & 0 & 0 & 0 \\ 0 & m_1 & 0 & 0 \\ 0 & 0 & \ddots & 0 \\ 0 & 0 & 0 & m_{K-1} \end{pmatrix} \cdot \begin{pmatrix} w_{0,1} & w_{0,2} & \cdots & w_{0,K} \\ w_{1,1} & w_{1,2} & \cdots & w_{1,K} \\ \vdots & \vdots & \ddots & \vdots \\ w_{N-1,1} & w_{N-1,2} & \cdots & w_{N-1,K} \end{pmatrix} \cdot \begin{pmatrix} c_{s,0} \\ c_{s,1} \\ \vdots \\ c_{s,K-1} \end{pmatrix} + \begin{pmatrix} e_{s \cdot N+0} \\ e_{s \cdot N+1} \\ \vdots \\ e_{s \cdot N+N-1} \end{pmatrix}$$

$$\underbrace{\phantom{h}}_{\underline{h}} \qquad \underbrace{\phantom{M}}_{\underline{M}} \qquad \underbrace{\phantom{W}}_{\underline{W}} \qquad \underbrace{\phantom{c}}_{\underline{c}} \qquad \underbrace{\phantom{e}}_{\underline{e}}$$

$$\underbrace{\phantom{MW}}_{\underline{W}^M}$$

Dabei werden die Matrixelemente $m_k$ der Maskierungsmatrix $\underline{W}$ jeweils entweder zu Null oder zu 1 gesetzt: = 0,1 mit k = 0 bis K - 1. Für die Gleichung 21 wird nun für jede mögliche Kombination von $m_k$ = 0,1 eine Optimierung hinsichtlich der kleinsten Fehlerquadrate durchgeführt. Der durch diese Suche optimale Satz von Gewichtungskoeffizienten für ein jeweiliges Segment s kann wie folgt dargestellt werden:

(Gl. 22)

$$\underline{c}_s^{opt} : \underbrace{\left(\underline{h} - \underline{M}_s^{opt} \cdot \underline{W} \cdot \underline{c}_s^{opt}\right)\left(\underline{h} - \underline{M}_s^{opt} \cdot \underline{W} \cdot \underline{c}_s^{opt}\right)^T}_{\equiv \sum_{r=0}^{N} |\underline{e}_s(n)|^2} < \frac{E_{max}}{S} \Bigg|_{\min\{rg(\underline{M}_s^{opt})\}} .$$

Auf das in Figur 12 dargestellte Beispiel einer Combfilter-Zielimpulsantwortfunktion und mit K = 6 für die maximale rekursive Ordnung des erfindungsgemäßen digitalen Filters zur Realisierung dieser Zielimpulsantwortfunktion lässt sich bei einer vorgegebenen Toleranzschwelle $E_{max}$ = -88 dB durch die Suche der Koeffizientensätze mit den meisten zu Null gesetzten Koeffizienten eine Einsparung von 17% an benötigten Multiplikationen erzielen. Eine Optimierung durch Suche derjenigen Gewichtungskoeffizientensätze mit den meisten zu Null gesetzten Gewichtungskoeffizienten ergibt sich, dass $C_{00}$, $C_{01}$, $C_{24}$, $C_{34}$, $C_{35}$ zu Null gesetzt werden können, ohne die erforderliche Näherungsgüte zu verschlechtern.

In der Figur 13 sind die jeweiligen realisierten Frequenzgänge mit K = 6 6, 16 $H_{GIAD}$ (z) der Zielimpulsantwortfunktion $H_{smeared}$ (z) dargestellt. Insbesondere in dem Bereich bis $f_{norm}$ = 0,25 liegen die Kurven praktisch aufeinander. Die gepunktete Linie stellt dabei die Zielimpulsantwortfunktion $H_{smeared}$ (z) dar, die gestrichelte Linie die durch ein erfindungsgemäßes Filter realisierte Impulsantwortfunktion mit nicht verschwindenden Gewichtungskoeffizienten und die durchgezogene Linie stellt ein nach dem verbesserten erfindungsgemäßen Entwurfsverfahren realisiertes Filter dar, bei dem die zuvor genannten fünf Gewichtungskoeffizienten zu Null gesetzt sind. Die maximale Abweichung zwischen der Zielimpulsantwortfunktion und der realisierten Zielimpulsantwortfunktion ist hier $E_{max}$ = -85 db gewählt.

Durch das verbesserte Entwurfsverfahren wird somit zunächst ein unterbestimmtes Gleichungssystem zur Bestimmung der Gewichtungskoeffizienten in dem jeweiligen Segment generiert und dann jeweils Probegewichtungskoeffizientensätze verwendet, bei denen ein oder mehrere Gewichtungskoeffizienten zu Null gesetzt sind. Zur Realisierung des erfindungsgemäßen Filters werden dann die Probegewichtungskoeffizientensätze ausgewählt, bei denen die meisten Gewichtungskoeffizienten zu Null gesetzt sind, und gleichzeitig die maximale Abweichung $E_{max}$ unterhalb der vorgegebenen Toleranzschwelle liegt.

Eine weitere Reduzierung der notwendigen Multiplikationen bzw. der zu implementierenden Addierer und Multiplizierer in dem Gewichtungsnetzwerk kann bei Verwendung von symmetrischen Zielimpulsantwortfunktionen erreicht werden.

Da erfindungsgemäß die Zielimpulsantwortfunktion segmentweise realisiert wird, müssen zur Ausnutzung der Symmetrie die Segmente symmetrisch auf die Stützstellen der Zielimpulsantwortfunktionen aufgeteilt werden. Am Beispiel der Combfilterfunktion mit verschobenen Nullstellen wird dies näher erläutert:

$$\text{(Gl. 23)} \qquad H^{\text{smeared}}(z) = \underbrace{\sum_{i=0}^{L-1} h_i z^{-i}}_{\text{FIR Moden}} = \underbrace{\sum_{i=0}^{L/2-1} h_i \overbrace{\left(z^{-i} + z^{L-1-i}\right)}^{\text{gemeinsam verwendete Multiplikationen}}}_{\text{symmetrische Moden}}.$$

Um die Symmetrie dieser Zielimpulsantwortfunktionen im Rahmen der erfindungsgemäßen Filteranordnungen auszunutzen, müssen die Segmente derart symmetrisch gelegt werden, dass jeweils Paare von Segmenten mit zueinander symmetrischen Zielimpulsantwortfunktionen vorliegen.

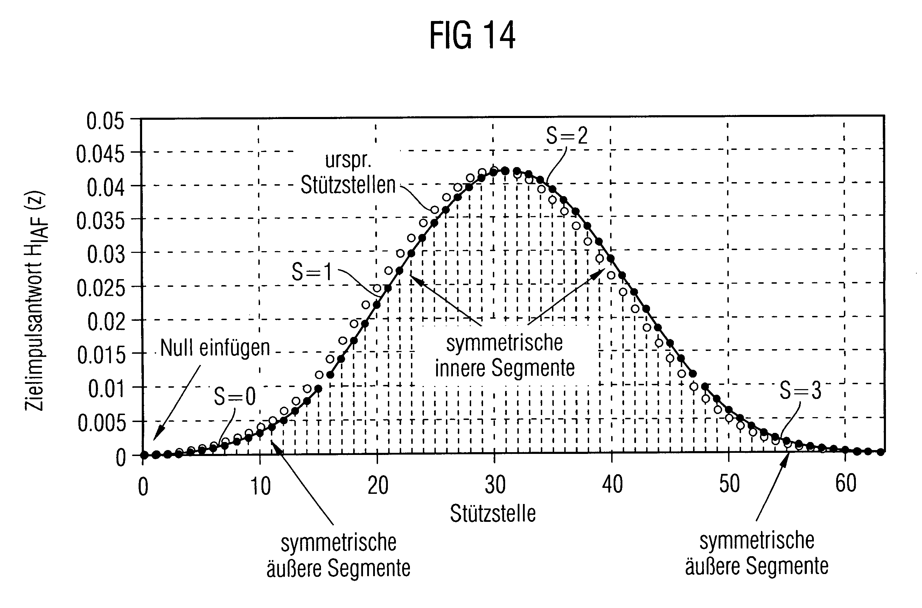

Die Figur 14 illustriert, wie eine symmetrische Impulsantwortfunktion zur Verarbeitung mit einem symmetrischen erfindungsgemäßen Filter bearbeitet werden kann. Um zwei symmetrische innere Segmente zu erzielen, wurde eine Null-Stützstelle bei 0 eingefügt, sodass die Zielimpulsantwortfunktion eine gerade Länge bzw. eine gerade Anzahl von Stützstellen aufweist. Bei dem hier gewählten Abtastratenumsetzfaktor N = 16 ergeben sich so 64 Stützstellen. Die Segmente s = 0 und s = 3 sowie die Segmente s = 1 und s = 2 sind damit symmetrisch zueinander. Das bedeutet, dass in einer erfindungsgemäßen Umsetzung prinzipiell dieselben Werte durch das digitale Filter berechnet werden bzw. dass sich Paare gleicher Gewichtungskoeffizienten auffinden lassen. Die Multiplikation mit diesen identischen Gewichtungskoeffizienten können daher für mehrere Segmente gleichzeitig verwendet werden, wodurch Rechen- und Implementierungsaufwand eingespart wird.

Die Anzahl der benötigten Segmente bei einer derartig vorbereiteten Zielimpulsantwortfunktion mit gerader Symmetrie lautet daher:

$$S^{\text{half}} = \left\lceil \frac{L}{2N} \right\rceil$$

$$\text{(Gl. 24)} \qquad L^{\text{half}} = N \cdot S^{\text{half}} = 16 \cdot 2 = 32 \qquad ,$$

$$L^{\text{ins}} = L^{\text{app}} = L^{\text{half}} - \frac{L}{2} = 32 - \frac{62}{2} = 1$$

wobei eine Rundung auf die nächstgrößere ganze Zahl vorgenommen wurde. Eine entsprechend gewünschte symmetrische Gewichtungskoeffizientenmatrix $\underline{C}^{\text{SYM}}$ kann geschrieben werden als:

$$\text{(Gl. 25)}$$

$$\underline{C}^{\text{sym}} = \begin{pmatrix} \underline{c}_0 & \underline{c}_1 & \cdots & \underline{c}_{S^{\text{half}}-1} \mid \underline{c}_{S^{\text{half}}-1} & \cdots & \underline{c}_1 & \underline{c}_0 \end{pmatrix} = \begin{pmatrix} \underline{C}^{\text{sym}}_{\text{left}} \mid \underline{C}^{\text{sym}}_{\text{right}} \end{pmatrix}$$

$$= \begin{pmatrix} \underbrace{\begin{matrix} C_{0,0} & C_{0,1} & \cdots & C_{0,S^{\text{half}}-1} \\ C_{1,0} & C_{1,1} & \cdots & C_{1,S^{\text{half}}-1} \\ \vdots & \vdots & \ddots & \vdots \\ C_{K-1,0} & C_{K-1,1} & \cdots & C_{K-1,S^{\text{half}}-1} \end{matrix}}_{\underline{C}^{\text{sym}}_{\text{left}}} \; \Bigg| \; \underbrace{\begin{matrix} C_{0,S^{\text{half}}-1} & \cdots & C_{0,1} & C_{0,0} \\ C_{1,S^{\text{half}}-1} & \cdots & C_{1,1} & C_{1,0} \\ \vdots & \ddots & \vdots & \vdots \\ C_{K-1,S^{\text{half}}-1} & \cdots & C_{K-1,1} & C_{K-1,0} \end{matrix}}_{\underline{C}^{\text{sym}}_{\text{right}}} \end{pmatrix}.$$

Dadurch ergibt sich für die durch das erfindungsgemäße Filter realisierte Impulsantwortfunktion

$$(Gl. \ 26) \qquad \underline{H}^{GIAD} = \underline{W} \cdot \underline{C}^{sym} = \underline{H} - \underline{E},$$

wobei eine symmetrische Impulsantwortmatrix erwünscht ist :

$$(Gl. \ 27)$$

$$\underline{H}^{SYM-GIAD} = \begin{pmatrix} \underline{h}_0 & \underline{h}_1 & \cdots & \underline{h}_{S^{half}-1} & \Big| & \underline{h}^{flip}_{S^{half}-1} & \cdots & \underline{h}^{flip}_1 & \underline{h}^{flip}_0 \end{pmatrix} = \begin{pmatrix} \underline{H}^{SYM-GIAD}_{left} & \Big| & \underline{H}^{SYM-GIAD}_{right} \end{pmatrix}$$

$$\underline{h}^{flip}_s = \begin{pmatrix} h^{flip}_{0,s} & h^{flip}_{1,s} & \cdots & h^{flip}_{N-1,s} \end{pmatrix}^T = \begin{pmatrix} h_{N-1,s} & \cdots & h_{1,s} & h_{0,s} \end{pmatrix}^T = \texttt{flipud}\begin{pmatrix} \underline{h}^{flip}_s \end{pmatrix},$$

Dabei bezeichnet flipup eine Abbildung flipup (a, b, c) + (c, b, a).

Die die Struktur des erfindungsgemäßen Filters beschreibende Matrix $\underline{w}$ muss daher modifiziert werden. Die ersten beiden Segmente, wie sie in der Figur 14 mit s = 0 und s = 1 bezeichnet wurden, lassen sich allgemein wie in den vorherigen Gleichungen beschrieben. Um symmetrische allgemeine Filter mittels einer erfindungsgemäßen Architektur zu beschreiben, ergibt sich beispielsweise für ein Interpolationsfilter:

$$(Gl. \ 28) \qquad \begin{aligned} \underline{H}^{SYM-GIAD}_{left} &= \underline{W}^{sym}_{left} \cdot \underline{C}^{sym}_{left} \\ \underline{H}^{SYM-GIAD}_{right} &= \underline{W}^{sym}_{right} \cdot \underline{C}^{sym}_{right} \end{aligned} \ .$$

Die symmetrische Erweiterung mit dem Index "right" muss dann die folgende Form aufweisen:

$$(Gl. \ 29) \qquad \begin{aligned} \underline{H}^{SYM-GIAD}_{right} &= \texttt{flipud}\begin{pmatrix} \underline{H}^{SYM-GIAD}_{left} \end{pmatrix} \\ \underline{C}^{sym}_{right} &= \texttt{fliplr}\begin{pmatrix} \underline{C}^{sym}_{left} \end{pmatrix} \end{aligned}$$

$$\underline{W}^{sym}_{right} = \texttt{flipud}\begin{pmatrix} \underline{W}^{sym}_{left} \end{pmatrix}.$$

In der Implementierung laufen die Gleichungen 27 bis 29 auf eine Zeitumkehr für die rechten ("right") Segmente hinaus.

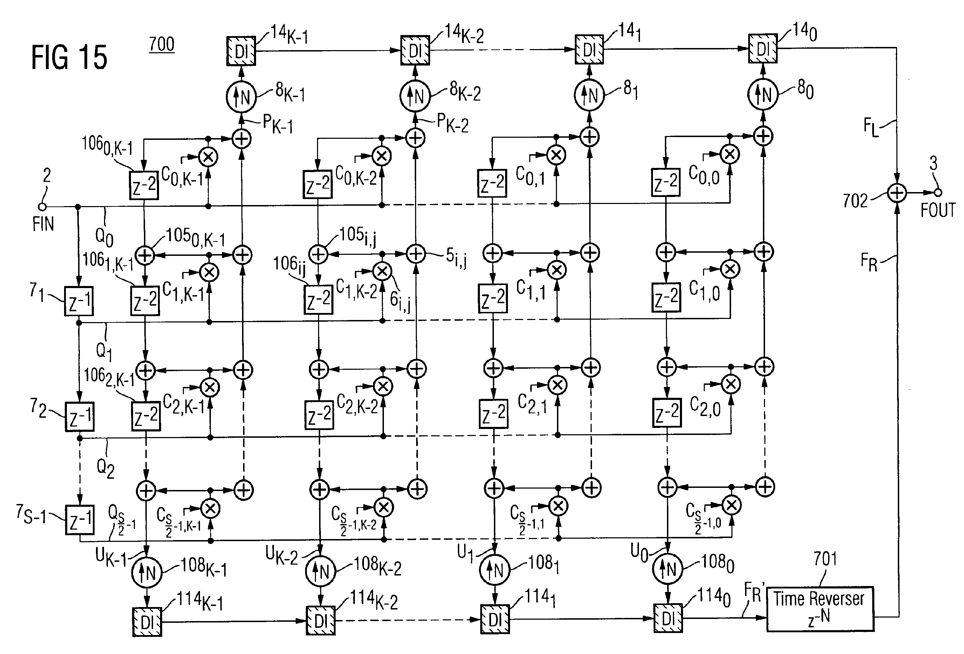

In der Figur 15 ist ein erfindungsgemäßes Interpolationsfilter 700 zur Realisierung einer symmetrischen Zielimpulsantwortfunktion dargestellt. Dabei ist im Wesentlichen ein Gewichtungsnetzwerk, wie es in der Figur 4 bereits dargestellt ist, verwendet, wobei jedoch die jeweils den Gewichtungskoeffizienten $C_{ij}$ zugeordneten Multiplizierern $6_{i,j}$ auch Signale für den symmetrischen rechten Anteil der Zielimpulsantwortfunktion erzeugen, die jeweils weiteren Addierern $105_{i,j}$ zugeführt werden. Es werden daher weitere Vorladesignale $U_j$ mit j = 0 bis K - 1 erzeugt, die weiteren Auftasteinrichtungen $108_j$ zugeführt werden. Bei der Bezeichnung der Addierer, Multiplizierer und Auftaster ist dieselbe Notation wie in den Figuren 1 bis 4 vorgenommen worden, auch wenn nicht alle Elemente explizit mit Bezugszeichen versehen sind.

Zur Realisierung der jeweiligen symmetrischen rechten Segmente der Zielimpulsantwortfunktion werden die internen verzögerten Signale $Q_i$ mit i = 0 bis S/2 - 1 mit den Gewichtungskoeffizienten multipliziert und um eine Verzögerungszeit verzögert, die dem jeweiligen Gewichtungskoeffizienten zugeordnet ist. Die so gewichteten und verzögerten internen Signale werden dann zur Linearkombination zusammengefasst und einer jeweiligen Auftasteinrichtung $108_j$

zugeführt.

Bei dem in Figur 14 dargestellten Ausführungsbeispiel des Interpolationsfilters 700 sind weitere Verzögerungsglieder $106_i$ mit i = 0 bis S/2 - 2 vorgesehen. Jeder Spalte der Gewichtungskoeffizientenmatrix ist somit eine Kette von weiteren seriell verschalteten Verzögerungsgliedern $106_{ij}$ zugeordnet, wobei zwischen den Verzögerungsgliedern $106_{ij}$ jeweils ein Addierer $105_{ij}$ vorgesehen ist, dem das jeweilige verzögerte interne und mit einem Gewichtungsfaktor gewichtete Signal zugeführt ist.

Die Verzögerungsglieder $106_{ij}$ weisen jeweils eine Verzögerung von $z^{-2}$ in der Basisbandrate auf. Die so jeweils erzeugten weiteren symmetrischen Vorladesignale $U_j$ mit j = 0 bis K - 1 werden von den weiteren Auftasteinrichtungen $108_j$ an die Filtereinheiten bzw. Integrations- und Löschfilter $114_j$ mit j = 0 bis K - 1 geführt.

Die hier mit $14_j$ bzw. $114_j$ bezeichneten Integrations- und Löschfilter entsprechen dabei beispielsweise den in der Figur 5 dargestellten, in Serie verschalteten Verzögerungsgliedern.

Die erste Kette von Verzögerungsgliedern $14_j$ liefert ein erstes symmetrisches Filtersignal $F_L$ und die zweite Kette von Verzögerungsgliedern $114_j$ ein zweites symmetrisches Filtersignal $F_R$'.

Der zweiten Kette von als Integrations- und Löschfilter verschalteten Verzögerungsglieder $114_j$ ist eine Zeitumkehreinrichtung 701 ausgangsseitig nachgeschaltet, welche ein zweites zeitumgekehrtes Filtersignal $F_R$ ausgibt. Die Signale $F_L$ und $F_R$ werden mittels eines Addierers 702 zu dem Filterausgangssignal FOUT zusammengeführt.

Durch die Anordnung der zusätzlichen Verzögerungsglieder $106_{ij}$ mit jeweiligen Verzögerungsfaktor $z^{-2}$ im Basisband, dem weiteren Auftaster $108_j$ und Filtereinrichtung 114 sowie der Zeitumkehreinrichtung 107 werden die symmetrischen rechten Segmente richtig in dem Filter umgesetzt.

Das Interpolationsfilter 700 gemäß der Figur 14 liefert daher mit einem um die Hälfte verminderten Implementierungsaufwand mit hoher Genauigkeit die gewünschte symmetrische Zielimpulsantwortfunktion. Gegenüber der nicht symmetrischen Ausführung, beispielsweise wie in den Figuren 1 bis 5 dargestellt ist, werden nur halb so viele Multiplikationen mit verschiedenen Gewichtungskoeffizienten durchgeführt.

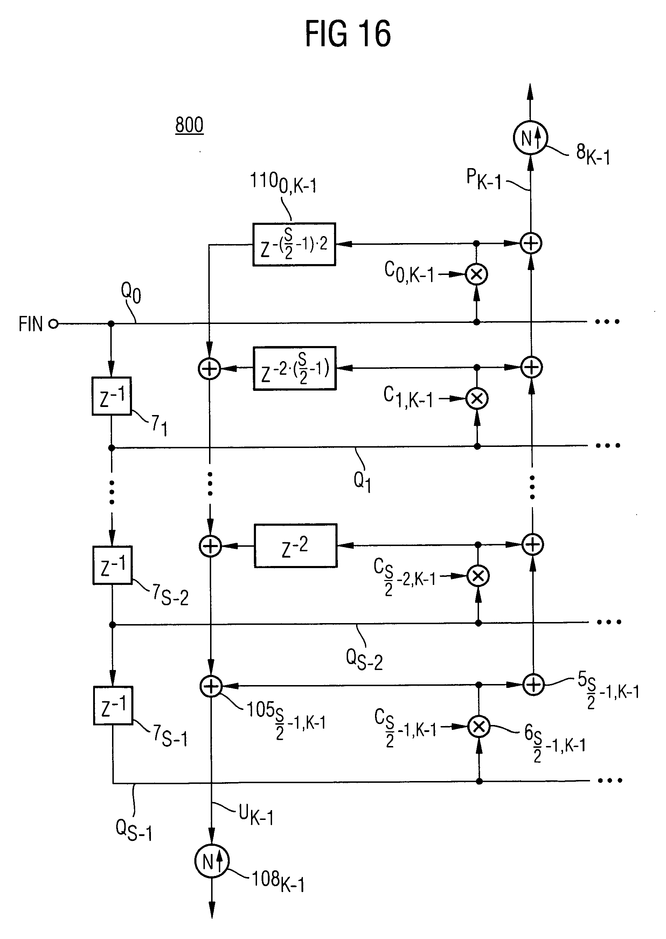

Alternativ zu der Kette von weiteren Verzögerungsgliedern $106_{i,j}$ lassen sich alternativ die von den Multiplizierern $6_{i,j}$ gelieferten gewichteten internen Signale auch zunächst mit verschieden ausgestalteten Verzögerungsgliedern verzögern und dann über eine Addiererkette zusammenführen. Ein entsprechendes Ausführungsbeispiel ist in der Figur 16 dargestellt. Die jeweiligen verzögerten internen Signale $Q_i$ werden zunächst über den Multiplizierer 6 mit dem Gewichtungskoeffizienten multipliziert und dann in zugeordneten Verzögerungseinrichtungen $110_{i,j}$ verzögert. Einem Gewichtungskoeffizienten $C_{i,j}$ ist dabei jeweils eine Verzögerung $z^{-2}$ (S/2 - 1 - i) zugeordnet.

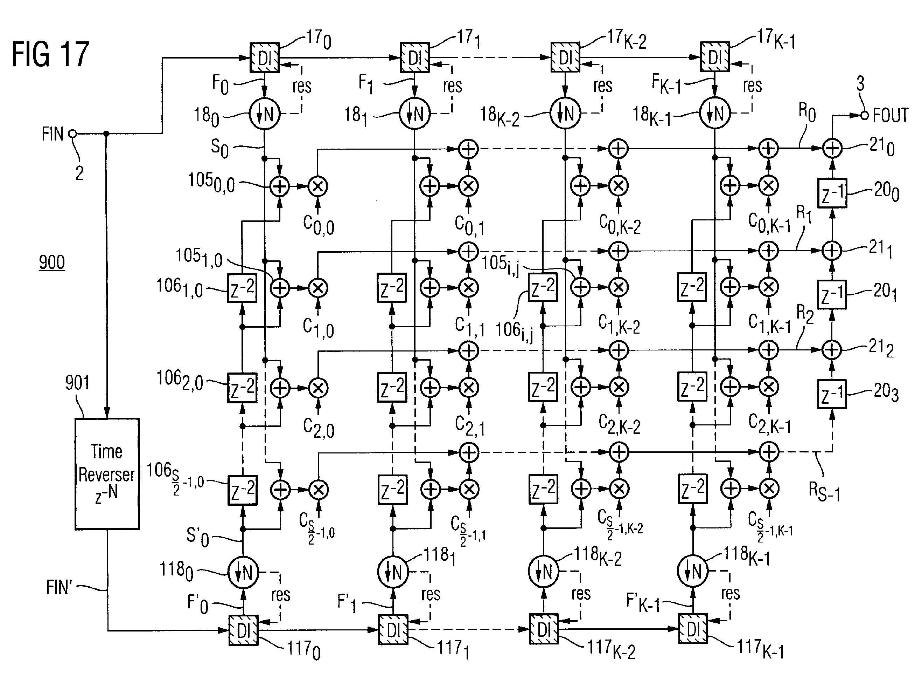

In der Figur 17 ist ein entsprechendes Dezimationsfilter 900 zur Realisierung einer symmetrischen Zielimpulsantwortfunktion dargestellt. Wie bereits in der Figur 15 dargestellt, sind weitere Abtasteinrichtungen $118_j$ mit j = 0 bis K - 1 vorgesehen sowie weitere Integrations- und Löschfiltereinheiten $117_j$ bzw. seriell verschaltete rückgekoppelte Verzögerungsglieder. Dem Eingang 2 des symmetrischen Dezimationsfilters 900 ist eine Zeitumkehreinrichtung 901 angekoppelt, die ein zeitumgekehrtes Eingangssignal FIN' an die Kette von weiteren Integrations- und Löschfiltern $117_j$ liefert. Den Abtasteinrichtungen $118_j$ werden jeweils Filtersignale $F_j$' zugeführt.

Einer jeweiligen weiteren Abtasteinrichtung $118_j$ ist eine Kette von seriell verschalteten Verzögerungsgliedern $106_{i,j}$ angekoppelt. Die Verzögerungsglieder $106_{i,j}$ weisen jeweils eine Verzögerung von $z^{-2}$ auf und liefern verzögerte Abtastsignale an die Addierer $105_{i,j}$. Die jeweiligen Segmentsignale $R_j$ ergeben sich so als Linearkombination der Summen der ersten Abtastsignale S0, welche den linken Segmenten entsprechen, und den jeweiligen verzögerten weiteren (rechten) Abtastsignalenen S0' der weiteren Abtasteinrichtung $118_j$.

Die Eigenschaften der erfindungsgemäßen digitalen Filter zur Abtastratenumsetzung eignen sich besonders zum Einsatz in Polyphasen-Filtern. Aufgrund des Aufbaus des jeweiligen digitalen Filters mit Gewichtungsnetzwerk, Integrations- und Löschfilterkette sowie gegebenenfalls symmetrischer Ausführung eignen sie sich besonders zum Einsatz in Polyphasen-Filtern.

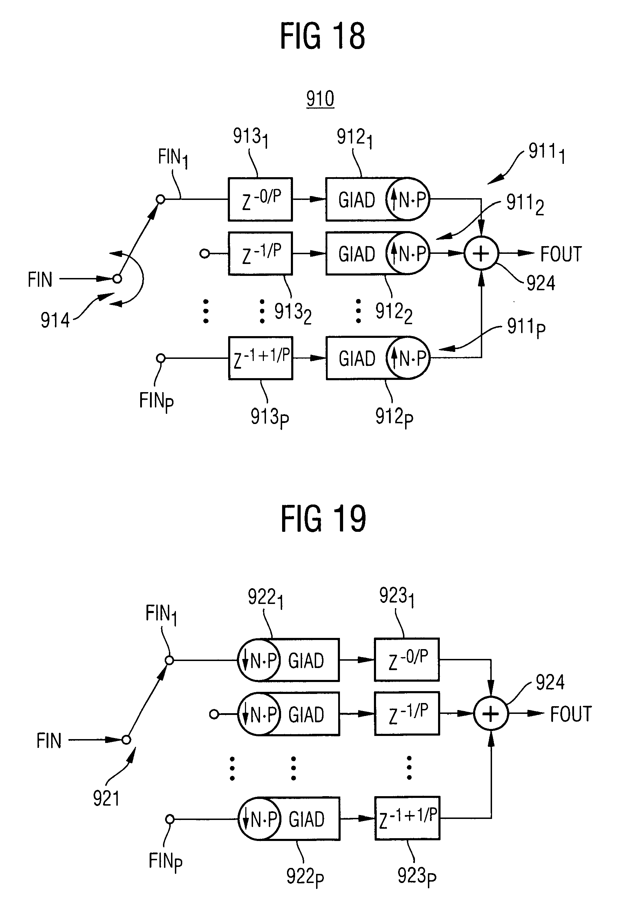

In den Figuren 18 und 19 sind Polyphasen-Anordnungen für ein Interpolationsfilter 910 und ein Dezimationsfilter 920 mittels der erfindungsgemäßen digitalen Filter dargestellt.

Das Interpolationsfilter weist eine Anzahl P Filterzweige $911_r$ mit r = 1 bis P auf, die jeweils ein erfindungsgemäßes Interpolationsfilter $912_r$ und eine vorgeschaltete Verzögerungseinrichtung $913_r$ aufweisen. Dabei hat die Verzögerungseinrichtung $913_1$ des ersten Filterzweiges $911_1$ keine Verzögerung, die zweite Verzögerungseinrichtung $913_2$ eine Verzögerung von $z^{-1/P}$, wobei ein r-ter Filterzweig jeweils eine Verzögerungseinrichtung mit einer Verzögerung um $z^{-1+1/r}$ aufweist. Ein Addierer 924 führt die gefilterten Zweigsignale zusammen. Eingangsseitig ist eine Umschalteinrichtung 914 vorgesehen, die das Eingangssignal FINauf die Filterzweige $911_r$ verteilt. Der niedrigratige Datenstrom des Eingangssignals FIN wird so durch die digitale Filteranordnung $912_r$ eines jeweiligen Filterzweiges mit einer P-fach niedrigeren Taktfrequenz betrieben.

Eine analoge Ausführung als Polyphasen-Dezimationsfilter ist in der Figur 19 dargestellt. Das Dezimationsfilter 920 weist eine Umschalteinrichtung 921 auf, die taktweise ein hochratiges Eingangssignal FIN in P Zweigsignale $FIN_r$ mit r = 1 bis P in die P Filterzweige aufspaltet. Die Zweigsignale $FIN_r$ weisen dabei eine P-fach verlängerte Abastrate auf. Die Zweigsignale werden hier als Dezimationsfilter ausgeführte erfindungsgemäße Filteranordnungen $922_r$ mit r =

1 bis P zugeführt, denen jeweils eine Verzögerungseinrichtung $923_r$ mit nachgeschaltet ist, welche jeweils ein Ausgangszweigsignal an einen Addierer 924 liefert. Der Addierer 924 führt die einzelnen Ausgangssignale der Zweigfilter zu dem Ausgangssignal FOUT zusammen. Die jeweiligen erfindungsgemäßen Filter werden also jeweils mit einer um den Faktor P, also der Anzahl der Polyphasen verminderten Taktrate betrieben. Außerdem werden für die einzelnen Filterzweige dieselben Gewichtungskoeffizienten zur Realisierung einer bestimmten Zielimpulsantwortfunktion verwendet. Um eine Polyphasen-Filteranordnung auszubilden, sind lediglich Bruchteile von Verzögerungen mit jeweils einem Unterschied zueinander von 1/P vorzusehen. Die größte benötigte Verzögerung lautet $D_{max}$ = (P - 1) dividiert durch P.

Es ist daher möglich, beispielsweise bei einer Ausführung als Interpolations-Polyphasenfilter die Abtasteinrichtungen gemeinsam zu verwenden und mit einer nicht reduzierten Taktfrequenz zu betreiben. Die entsprechend anliegenden Abtastsignale können dann jeweils taktweise einer jeweiligen Kette von Integrations- und Löschfiltern zugeführt werden, welche eine Integratoreinrichtung im Sinne der Figur 4 bilden.

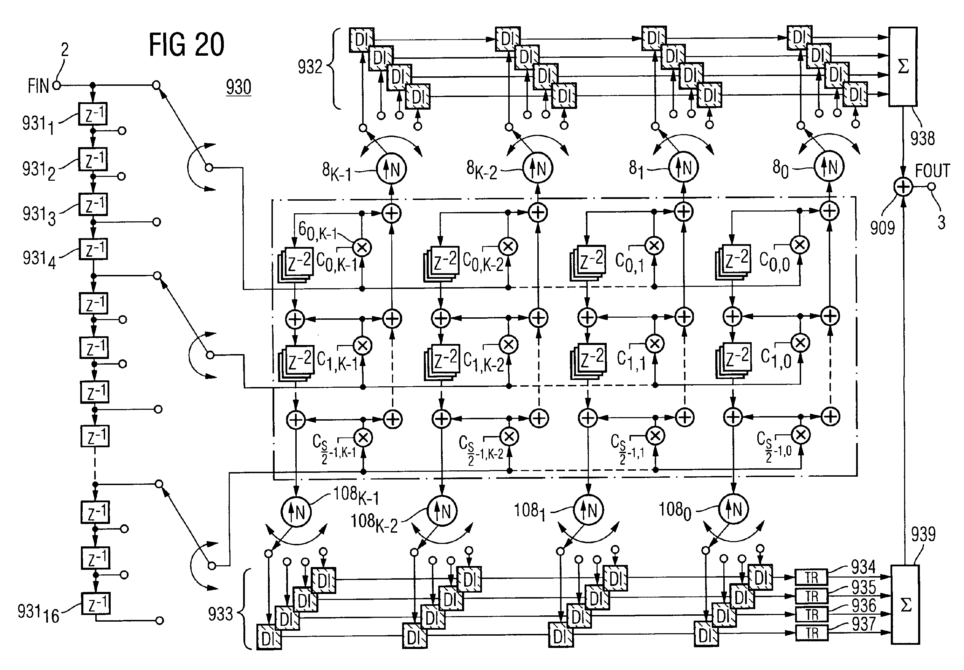

In der Figur 20 ist ein als Interpolationsfilter ausgeführtes Polyphasen-Filter 930 dargestellt. Es ist ein gemeinsames Gewichtungsnetzwerk 4 vorgesehen, welches hier eine symmetrische Struktur hat, wie es in der Ausführungsform 700 gemäß der Figur 15 näher erläutert ist. An dem Eingang 2 des Polyphasen-Filters 930 ist eine Kette 931 von seriell verschalteten Verzögerungsgliedern vorgesehen. Das hier dargestellte Beispiel hat P = 4 Polyphasen. Dabei ist jeder Zeile von Gewichtungskoeffizienten $C_{ij}$ bzw. den zugeordneten Multiplizerern $6_{i,j}$ ein verzögertes internes Signal zuführbar. In dem hier dargestellten Beispiel sind S/2 - 1 Zeilen vorgesehen. An den Eingang 2 des Polyphasen-Filters 930 sind also 4 (S/2 - 1) - 2 Verzögerungsglieder in Serie geschaltet. Zwischen den Verzögerungsgliedern $931_r$ sind jeweils die Zweigsignale abgreifbar.

Die Multiplikationen zur Berechnung der Linearkombination der nunmehr verzögerten internen Signale werden jeweils mit einer Verzögerung von 1/P der Basisbandabtastperiode ausgeführt. Somit wird das Gewichtungsnetzwerk 4 mit der üblichen Taktrate betrieben, gibt jedoch über die jeweiligen Auftasteinrichtungen $8_j$ bzw. $108_j$ Abtastsignale an die P = 5-fach vorgehaltenen Integrations- und Löschfilterketten 932, 933 aus. Die jeweiligen Filtereinheiten oder Integratoreinrichtungen für die Filter der P-Filterzweige müssen P-fach vorgehalten werden. Bei dem symmetrischen Aufbau, wie er in der Figur 20 dargestellt ist, sind demnach auch P = 4 Zeitumkehreinrichtungen 934, 935, 936, 937, die analog zur einzelnen Zeitumkehreinrichtung für die rechten symmetrischen Segmente, wie sie bezüglich der Figur 17 erläutert wurden, vorgehalten werden. Die so erzeugten symmetrischen Zweigsignale werden jeweils in einer Addiereinrichtung 938, 939 addiert und an eine dritte Addierereinrichtung 909 ausgegeben, die diese zu dem Ausgangssignal FOUT verknüpft.

Ein Vorteil der Polyphasen-Ausführung des erfindungsgemäßen Filters besteht darin, dass durch den effektiv um P reduzierten Abtastratenumsetzfaktor der einzelnen Zweige die Stützstellen zur Bestimmung der Filterkoeffizienten bzw. der Gewichtungskoeffizienten größere Abstände zueinander aufweisen können. Somit überdecken die jeweiligen durch die Filterzweige realisierten Impulsantwortfunktionen einen absolut größeren Bereich der Zielimpulsantwortfunktionen. Gegenüber der einfachen Ausführung ohne Polyphase liegen die Stützstellen bei gleichem Abtastratenumsetzfaktor N um jeweils P-Stützstellen auseinander. Gegebenenfalls wird dadurch eine bessere Approximation an die Zielimpulsantwortfunktion erreicht.

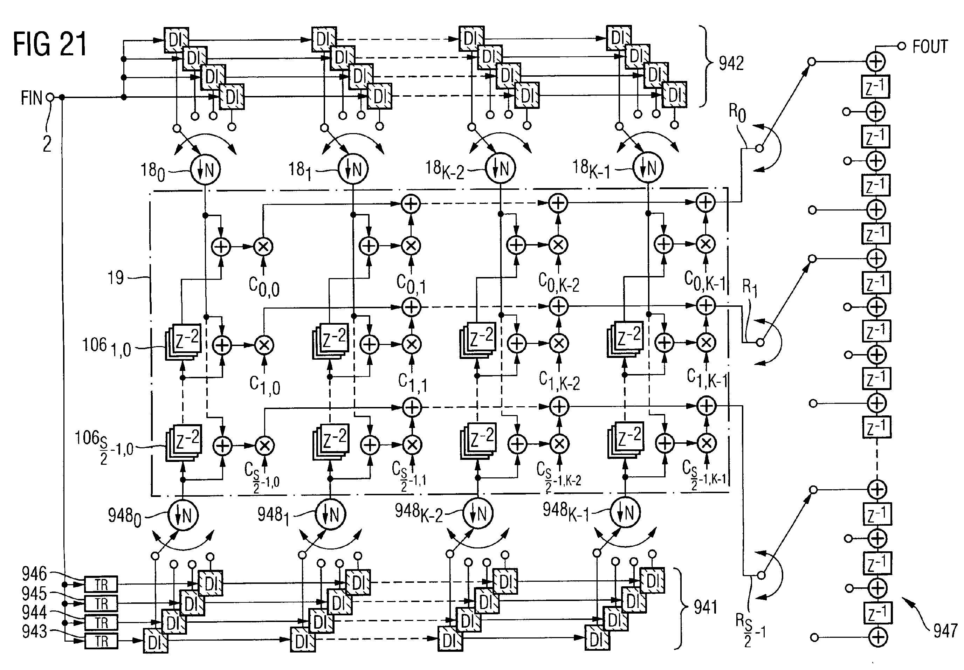

Die Figur 21 zeigt eine Polyphasenfilteranordnung gemäß der Erfindung als Dezimationsfilter 940. Das Eingangssignal FIN wird jeweils K = 4 Ketten von Integrations- und Löschfiltern 942 zugeführt, und da eine symmetrische Ausführung dargestellt ist, auch den zweiten Integrations- und Löschfiltern 941, denen in jeweils einer Zeitumkehreinrichtung 943, 944, 945, 946 vorgeschaltet ist, zugeführt. Es ist an ein gemeinsames Gewichtungskoeffizientennetzwerk 19 vorgesehen, das über die Abtasteinrichtungen $18_j$, $948_j$, wobei j = 0 bis K - 1 beträgt, gekoppelt. Die für die rechtssymmetrischen Abtastsignale notwendigen als Kette verschalteten Verzögerungsglieder $106_{i,j}$ müssen hier ebenfalls P-fach, also vierfach, vorgehalten werden. Die Segmentsignale, wie sie von dem Gewichtungsnetzwerk 19 geliefert werden, werden taktweise an einen zwischen den Verzögerungsgliedern einer Verzögerungsgliederkette vorgesehenen Addierer geführt. An dem Ausgang 3 der Polyphasen-Filtereinrichtung 940 ist demnach eine Kette von seriell verschalteten Verzögerungsgliedern 947 vorgesehen, wobei die Anzahl der Verzögerungsglieder P (S/2 - 1) - 1 beträgt.

Ein besonderer Vorteil der Polyphasen-Ausführung liegt in der Reduzierung des effektiven Interpolations- bzw. Dezimationsfaktors für die einzelnen Zweige, wobei die Segmentlänge bzw. die Anzahl der durch die Segmente überdeckten Stützstellen der Zielimpulsantwortfunktion von dem Dezimations- bzw. Interpolationsfaktor N abhängt. Bei der Polyphasen-Filterausführung wird ein P-fach längerer Bereich von Stützstellen der Zielimpulsantwortfunktion überdeckt. Dadurch müssen insgesamt weniger Segmente und Segmentanschlüsse berücksichtigt werden. So lassen sich bessere Approximationen erzielen. In einem Optimalfall würde eine Kette von Integrations- und Löschfiltern mit einer vorgegebenen maximalen rekursiven Ordnung die vollständige Länge der Zielimpulsantwortfunktion überdecken. Insbesondere wird dadurch auch die Suche nach zu Null setzbaren Gewichtungskoeffizienten vereinfacht.

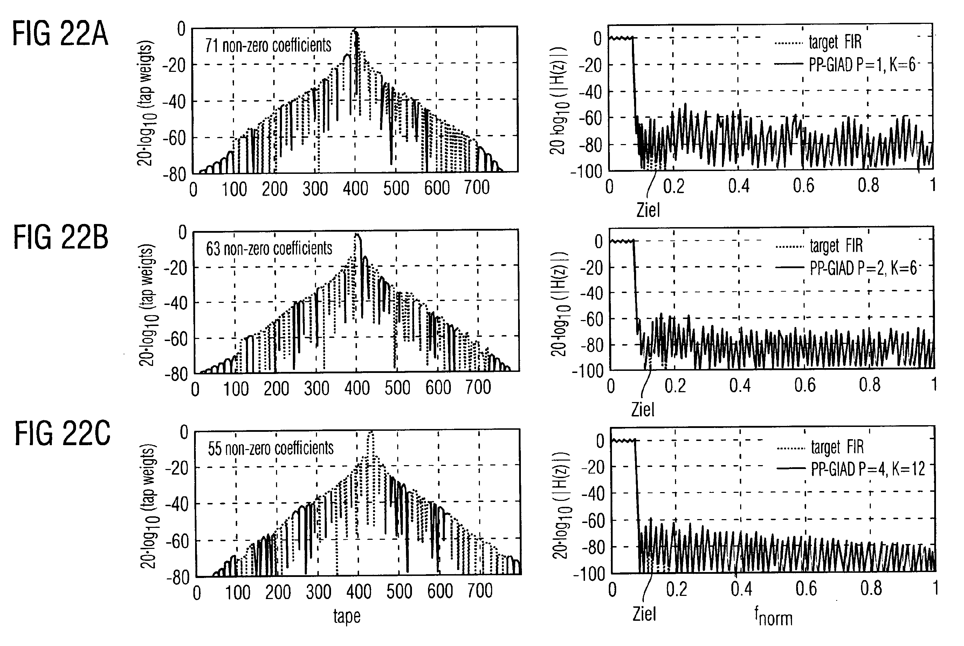

Die Figur 22 zeigt die Impulsantwort und Frequenzgänge von Polyphasen-Interpolationsfiltern mit einem Interpolationsfaktor N = 12 und einer Stoppbanddämpfung von -50 dB. Die Zeile (A) bezeichnet dabei ein einfaches erfindungsgemäßes Interpolationsfilter mit einer maximalen rekursiven Ordnung K = 6. Durch eine erfindungsgemäße Optimierung zum Auffinden von möglichst vielen zu Null setzbaren Gewichtungskoeffizienten sind 71 Gewichtungskoeffizienten ungleich Null. Die zweite Zeile zeigt (B) Impulsantwort und Frequenzgang eines erfindungsgemäßen Filters in Polyphasen-Ausführung mit P = 2, wobei die maximale Ordnung K = 8 ist. In diesem Fall sind lediglich 63 nicht verschwindende Gewichtungskoeffizienten notwendig. In der Zeile (C) ist eine vierfache Polyphase P = 4 verwendet, und eine maximale rekursive Ordnung von K = 12. Im letzteren Fall sind lediglich 55 Gewichtungskoeffizienten ungleich Null. Die Näherung an die Zielimpulsantwort verbessert sich zudem durch Erhöhung der rekursiven Ordnungen K und die Zahl der Polyphasen. Während die Dämpfung in Zeile (A) des Stoppbandes bei etwa -50 dB liegt, ist sie bei einer Zweifach-Polyphase bereits deutlich unter -50 dB und in der Zeile (C) mit einer Vierfach-Polyphase bereits bei -60 dB im gewünschten Sperrbereich.

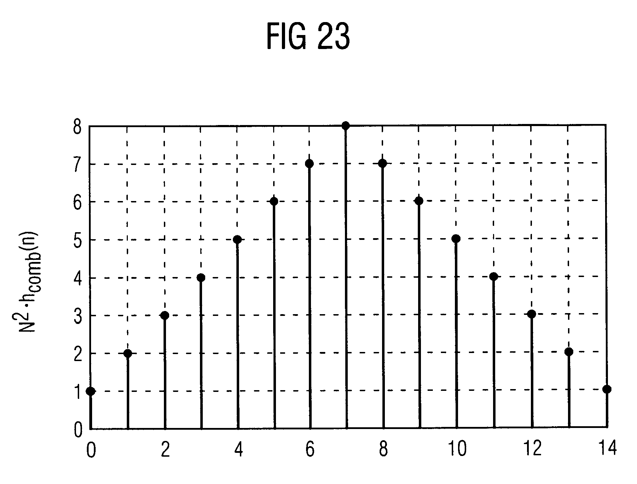

Eine weitere Möglichkeit, die erfindungsgemäßen Filter effizienter zu gestalten, besteht darin, die Dynamik der Integrationsketten bzw. der Integratoreinrichtungen zu begrenzen. Mit jeder Integrationsstufe bzw. mit jedem Integrations- und Löschfilter der Integrations- und Löschfilterkette steigt die Bitbreite des entsprechenden Ausgangssignals. Je höher diese Bitbreite ist, desto größere Anforderungen sind auch an die entsprechenden Gewichtungskoeffizienten hinsichtlich ihrer Quantisierung bzw. Genauigkeit zu stellen. Üblicherweise wird ein Ausgangssignal FOUT lediglich mit einer Bitbreite von etwa 16 Bits benötigt. Für eine in der Figur 23 dargestellten Zielimpulsantwort, die einer Impulsantwortfunktion eines Combfilters zweiter Ordnung entspricht, ergeben sich bei einem Interpolationsfaktor N = 8 die Gewichtungskoeffizienten

$$(\text{Gl. } 30) \qquad \underline{\underline{C}} = \begin{pmatrix} \underline{c}_0 & \underline{c}_1 \end{pmatrix} = \begin{pmatrix} c_{0,0} & c_{0,1} \\ c_{1,0} & c_{1,1} \end{pmatrix} = \begin{pmatrix} 0 & +\dfrac{1}{8} \\ 1 & -\dfrac{1}{8} \end{pmatrix}.$$

Durch Einfügen von Verschiebeeinrichtungen zwischen die Integrations- und Löschfiltereinheiten können günstiger skalierte Gewichtungskoeffizienten erzielt werden.

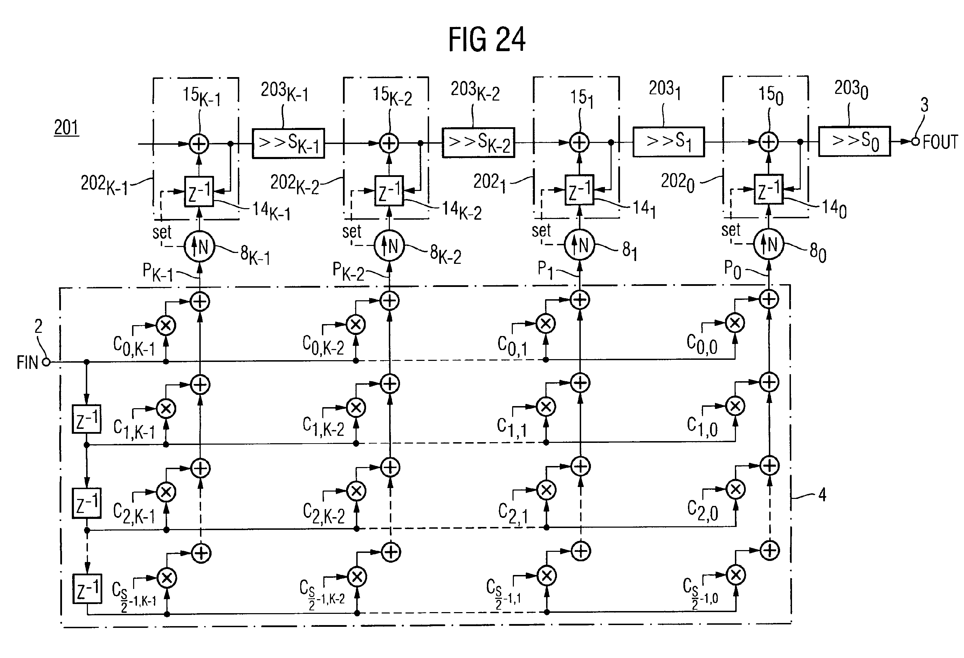

In der Figur 24 ist beispielsweise ein Interpolationsfilter 201 dargestellt, bei dem rückgekoppelte Integrations- und Löschfilter zu einer Ketter, wie in der Figur 4 dargestellt, zusammengeschaltet sind. Jede Integrations- und Löschfiltereinheit $202_j$ mit j = 0 bis K - 1 weist dabei jeweils ein rückgekoppeltes Verzögerungsglied $14_j$ und einen Addierer $15_j$ auf. Zwischen den Integrations- und Löschfiltern $202_j$ sind jeweils Verschiebeeinrichtungen $203_j$ vorgesehen. Durch die Verschiebeeinrichtung $208_j$ wird die Dynamik innerhalb der Kette von Integrations- und Löschfiltern erniedrigt. Ferner lassen sich die Gewichtungskoeffizienten besser skalieren.

Für das oben genannte Beispiel der in Figur 23 dargestellten Zielimpulsantwortfunktion ergibt sich bei einer Verschiebung für ein erfindungsgemäßes Interpolationsfilter zweiter Ordnung mit zwei Segmenten mit einem Verschiebefaktor von $S_0 = 0$ und $S_1 = 3$ die verbesserte Gewichtungsmatrix:

$$(\text{Gl. } 31) \qquad \underline{\underline{C}} = \begin{pmatrix} \underline{c}_0 & \underline{c}_1 \end{pmatrix} = \begin{pmatrix} c_{0,0} & c_{0,1} \\ c_{1,0} & c_{1,1} \end{pmatrix} = \begin{pmatrix} 0 & +1 \\ 1 & -1 \end{pmatrix}.$$

Zur Darstellung dieser Gewichtungsfaktoren sind nun jeweils nur noch zwei Bit notwendig.

Bei einem Interpolationsfaktor N und einer Kette von K Integrations- und Löschfiltern sowie einer rekursiven Ordnung von K realisierend, lässt sich die Anzahl der zusätzlich vorzusehenden Guard-Bits durch die Integrationsdynamik wie folgt ausdrücken:

$$D(K, N) = \left\lceil \log_2 \left\{ h_{INT}^K (N - 1) \right\} \right\rceil = \left\lceil \log_2 \begin{pmatrix} N - 1 + K - 1 \\ K - 1 \end{pmatrix} \right\rceil$$

Die Guard-Bits geben dabei den Zuwachs an Wortbreite pro Integrations- und Löschfiltereinheit an. Für N = 32 und K = 8 erhält man beispielsweise D (N, K) = 18 Guard-Bits, welche erfindungsgemäß durch acht Verschiebeeinrichtungen kompensiert werden können.

Die vorliegende Erfindung liefert digitale Filter, die zur Abtastratenumwandlung geeignet sind und praktisch beliebige Impulsantwortfunktionen realisieren können. Durch eine einfache Bestimmung von Gewichtungskoeffizienten kann die benötigte Genauigkeit zur Realisierung einer Zielimpulsantwortfunktion praktisch beliebig hoch gewählt werden. Verschiedene Verbesserungen liefern zudem besonders günstige Ausführungsformen deren Implementierungsaufwand niedrig ist, weil viele Gewichtungskoeffizienten zu Null gesetzt werden können. Durch den Einsatz von beispielsweise Integrations- und Löschfiltern ergibt sich nur ein mäßiger Zuwachs an Guard-Bits im Vergleich zu konventionellen Integrationsfiltern. Ein besonderer Vorteil der erfindungsgemäßen Filter besteht darin, dass eine Abtastratenumwandlung mittels nur einer einzigen Filterstufe realisiert ist, während nach dem Stand der Technik verschieden ausgestaltete Filter in verschiedenen Interpolations- oder Dezimationsstufen vorgehalten werden müssen, um einen vorgegebenen Abtastratenumsetzfaktor zu erreichen.

Bezugszeichenliste

| | |
|---|---|
| 1 | Interpolationsfilter |
| 2 | Eingang |
| 3 | Ausgang |
| 4 | Gewichtungsnetzwerk |
| 5 | Addierer |
| 6 | Multiplizierer |
| 7 | Verzögerungsglied |
| 8 | Auftasteinrichtung |
| 9 | Filtereinheit |
| 10 | Addierer |
| 11 | Leitungsknoten |
| 12 | Verzögerungsglied |
| 13 | Addierer |
| 114 | Dividierer |
| 14 | Verzögerungsglied |
| 15 | Addierer |
| 16 | Ausgangssignalpfad |
| 17 | Filtereinheit |
| 18 | Abtasteinrichtung |
| 19 | Gewichtungsnetzwerk |
| 20 | Verzögerungsglied |
| 21 | Addierer |
| 22 | Integratoreinheit |
| 23 | Verzögerungsglied |
| 24 | Addierer |
| 100 | Interpolationsfilter |
| 105 | Addierer |
| 106 | Verzögerungsglied |
| 108 | Auftasteinrichtung |
| 114 | Integrations- und Löschfilter |
| 117 | Integrations- und Löschfilter |
| 201 | Interpolationsfilter |
| 202 | Interpolations- und Löschfilter |
| 203 | Verschiebeeinrichtung |
| 700 | symmetrisches Interpolationsfilter |
| 701 | Zeitumkehreinrichtungen |
| 702 | Addierer |
| 800 | symmetrisches Interpolationsfilter |
| 901 | Zeitumkehreinrichtungen |
| 900 | Dezimationsfilter |
| 900 | symmetrisches Dezimationsfilter |
| 910 | Polyphasen-Interpolationsfilter |

| 909 | Addierer |
|---|---|
| 911 | Filterzweig |
| 912 | Interpolationsfilter |
| 913 | Verzögerungseinrichtung |
| 914 | Schalteinrichtung |
| 914 | Umschalteinrichtung |
| 920 | Polyphasen-Interpolationsfilter |
| 921 | Umschalteinrichtung |
| 922 | Dezimationsfilter |
| 923 | Verzögerungseinrichtung |
| 924 | Addierer |
| 930 | Polyphasen-Interpolationsfilter |
| 931 | Verzögerungsglied |
| 932 | Integrations- und Löschfilterketten |
| 933 | Integrations- und Löschfilterketten |
| 934, 937 | zweite Umkehreinrichtung |
| 938, 939 | Addierer |
| 940 | Polyphasen-Dezimationsfilter |
| 941, 942 | Ketten von Integrations- und Löschfiltern |
| 943, 946 | Zeitumkehreinrichtungen |

**Patentansprüche**

1. Digitales Filter (1, 500) zum Umsetzen eines digitalen Eingangssignals (FIN) in ein digitales Ausgangssignal (FOUT) mit jeweils einer unterschiedlichen Abtastrate:

a) mit mehreren Filtereinheiten (9, 17), die in einem Signalpfad zwischen einem Eingang (2) und einem Ausgang (3) des digitalen Filters (1, 500) jeweils voneinander unabhängige Filterfunktionen mit einer vorgegebenen rekursiven Filterordnung (k) realisieren, wobei jede Filtereinheit (9, 17) mindestens ein auf einen vorgebbaren Wert rücksetzbares Verzögerungsglied (12, 23) aufweist;
b) wobei jeder Filtereinheit (9, 17) eine Abtasteinrichtung (8, 18) zugeordnet ist, die das mindestens eine rücksetzbare Verzögerungsglied (12, 23) in Abhängigkeit von einem Abtastratenumsetzfaktor N auf einen vorgegebenen Wert setzt;
c) mit einem an die Abtasteinrichtungen (8, 18) gekoppelten Gewichtungsnetzwerk (4, 19) mit Gewichtungskoeffizienten ($C_{ij}$), wobei das digitale Eingangssignal (FIN) über das Gewichtungsnetzwerk (4) an eine jeweilige Abtasteinrichtung (8) geführt ist oder wobei von einer jeweiligen Abtasteinrichtung (18) ausgegebene digitale interne Abtastsignale ($S_j$) über das Gewichtungsnetzwerk (19) an den Ausgang (3) des digitalen Filters (500) geführt sind; und
d) wobei die Filtereinheiten (9, 17) und die Abtasteinrichtungen (8, 18) mit einer ersten Taktrate und das Gewichtungsnetzwerk (4, 19) mit einer zweiten Taktrate betrieben sind.

2. Filter (1, 500) nach Anspruch 1,
**dadurch gekennzeichnet,**
**dass** die Filtereinheiten (9, 17) zueinander orthogonale Filterfunktionen aufweisen.

3. Filter (1, 500) nach einem der Ansprüche 1 oder 2,
**dadurch gekennzeichnet ,**
**dass** eine jeweilige Filtereinheit (9, 17) eine Tschebyscheff, Butterworth-, oder Bessel-Filterfunktion der jeweiligen vorgegebenen Ordnung realisiert.

4. Filter (1, 500) nach einem der vorhergehenden Ansprüche 1 - 3,
**dadurch gekennzeichnet ,**
**dass** mindestens eine Filtereinheit (9) als Integrations- und Lösch-Filter ausgeführt ist.

5. Filter (1, 500) nach Anspruch 4,
**dadurch gekennzeichnet ,**
**dass** eine jeweilige Filtereinheit (9) eine Filterfunktion gemäß

$$H_{DI}^{k,N}(z) = \sum_{n=0}^{N-1} \binom{n+k-1}{K-1} z^{-n}$$

aufweist, wobei k die rekursive Ordnung der Filtereinheit (9) ist und N der Abtastratenumsetzfaktor.

6. Filter (1, 500) nach Anspruch 4 oder 5,
   **dadurch gekennzeichnet ,**
   **dass** eine jeweilige Filtereinheit (9) eine der vorgegebenen rekursiven Ordnung (k) entsprechenden Anzahl von rücksetzbaren Verzögerungsgliedern (12) aufweist, welche rückgekoppelt als eine Integratoreinrichtung verschaltet sind, wobei die jeweilige zugeordnete Abtasteinrichtung (8) ein Rücksetzsignal (RES) für die Verzögerungsglieder (12, 14) erzeugt.

7. Filter (1, 500) nach Anspruch 4 oder 5,
   **dadurch gekennzeichnet ,**
   **dass** eine jeweilige Filtereinheit genau ein rückgekoppeltes Verzögerungsglied (14) aufweist.

8. Filter (1, 500) nach einem der vorhergehenden Ansprüche 4 - 6,
   **dadurch gekennzeichnet ,**
   **dass** die Filtereinheiten zu einer Integratorstufe (15, 22) zusammengefasst sind, wobei eine einer maximalen vorgegebenen rekursiven Ordnung entsprechende Anzahl von einzeln rückgekoppelten rücksetzbaren Verzögerungsgliedern (14, 23) vorgesehen sind, welche seriell miteinander verschaltet sind, und wobei jeweils eine zugeordnete Abtasteinrichtung (8) an einen Eingang eines jeweiligen rückgekoppelten Verzögerungsglied (14) gekoppelt ist und dasselbe rücksetzt.

9. Filter (201) nach Anspruch 8,
   **dadurch gekennzeichnet ,**
   **dass** jedem rückgekoppelten rücksetzbaren Verzögerungsglied (202) ausgangsseitig eine Verschiebeeinrichtung (203) nachgeschaltet ist, welche ein jeweiliges digitales Signal um eine vorgegebene Anzahl von Bits verschiebt.

10. Filter (100) nach einem der vorhergehenden Ansprüche 1 - 9,
    **dadurch gekennzeichnet ,**
    **dass** das digitale Filter als Interpolationsfilter ausgeführt ist, wobei

    a) das Gewichtungsnetzwerk (4) eine an den Eingang des Filters gekoppelte Verzögerungsgliedkette (7) von seriell geschalteten Verzögerungsgliedern (7) aufweist, wobei an Leitungsknoten ($11_i$) der Verzögerungsgliedkette verzögerte interne Signale ($Q_i$) abgreifbar sind; und wobei
    b) das Gewichtungsnetzwerk (4) derart Vorladesignale ($P_j$) für die Abtasteinrichtungen (8) erzeugt, dass ein jeweiliges Vorladesignal ($P_i$) einer Summe der mit Gewichtungskoeffizienten ($C_{ij}$) gewichteten verzögerten internen Signale ($Q_i$) entspricht.

11. Filter (100) nach Anspruch 10,
    **dadurch gekennzeichnet ,**
    **dass** die rücksetzbaren Verzögerungsglieder (12) jeweils zu einem N-ten Takt durch die zugeordnete Abtasteinrichtung (8) auf einen dem Vorladesignal ($P_j$) entsprechenden Wert rückgesetzt werden.

12. Filter (500) nach einem der vorhergehenden Ansprüche 1 - 9,
    **dadurch gekennzeichnet ,**
    **dass** das digitale Filter als Dezimationsfilter ausgeführt ist, wobei

    a) das Gewichtungsnetzwerk (19) eine an den Ausgang (3) des Filters gekoppelte Verzögerungsgliedkette (20) von seriell geschalteten Verzögerungsgliedern aufweist, wobei Leitungsknoten (21) zwischen den Verzögerungsgliedern der Verzögerungsgliedkette vorgesehen sind; und wobei
    b) das Gewichtungsnetzwerk (19(derart Segmentsignale für die Leitungsknoten (21) der Verzögerungsgliedkette (20) erzeugt, dass ein jeweiliges Segmentsignal ($R_i$) einer Summe der mit Gewichtungskoeffizienten ($C_{ij}$) gewichteten internen Abtastsignale ($S_i$) entspricht.

13. Filter (500) nach Anspruch 12,

**dadurch gekennzeichnet ,**
**dass** die rücksetzbaren Verzögerungsglieder (23) jeweils zu einem N-ten Takt durch die zugeordnete Abtasteinrichtung (18) auf Null zurückgesetzt werden.

**14.** Filter (1, 500) nach einem der vorhergehenden Ansprüche 10 - 13,
**dadurch gekennzeichnet ,**
**dass** die Verzögerungsgliedkette (7, 20) eine Anzahl von Verzögerungsgliedern (7, 20) aufweist, welche einer maximalen vorgegebenen rekursiven Filterordnung entspricht.

**15.** Filter (1, 500) nach einem der vorhergehenden Ansprüche 10 - 14,
**dadurch gekennzeichnet ,**
**dass** jedem Gewichtungskoeffizienten ($C_{ij}$), der ungleich Null ist, ein Multiplizierer ($6_{ij}$) und ein Addierer ($5_{ij}$) zugeordnet ist.

**16.** Filter (1, 500) nach einem der vorhergehenden Ansprüche 1 - 15,
**dadurch gekennzeichnet ,**
**dass** jeder Filtereinheit (9, 17) ausgangsseitig eine Verschiebeeinrichtung (203) nachgeschaltet ist, welche ein jeweiliges digitales Signal um eine vorgegebene Anzahl von Bits verschiebt.

**17.** Filter (1, 500) nach einem der vorhergehenden Ansprüche 1 - 16,
**dadurch gekennzeichnet ,**
**dass** die Anzahl der Abtasteinrichtungen (8, 18) einer vorgegebenen Approximationsfilterordnung K entspricht, mit welcher das digitale Filter eine Zielfilterfunktion realisiert.

**18.** Filter (1, 500) nach einem der vorhergehenden Ansprüche 9 - 17,
**dadurch gekennzeichnet ,**
**dass** das Filter eine L Stützstellen lange Zielfilterfunktion ($H_{IAF}(z)$) approximiert, wobei die Anzahl S der seriell geschalteten Verzögerungsglieder der Verzögerungsgliedkette (7,

20) $S = \left\lceil \dfrac{L}{N} \right\rceil$ beträgt.

**19.** Filter (700, 800) nach einem der vorhergehenden Ansprüche 9 - 17,
**dadurch gekennzeichnet ,**
**dass** das Filter eine symmetrische FIR-Filterfunktion aufweist, wobei über weitere Abtasteinrichtungen (108, 118) an das Gewichtungsnetzwerk (4, 19) gekoppelte weitere Filtereinheiten (114, 117) vorgesehen sind.

**20.** Filter (700, 800) nach Anspruch 10 und 19,
**dadurch gekennzeichnet ,**
**dass** das Gewichtungsnetzwerk (4, 19) derart weitere Vorladesignale ($U_j$) für die weiteren Abtasteinrichtungen (108) erzeugt, dass ein jeweiliges weiteres Vorladesignal ($U_j$) einer Summe der mit Gewichtungskoeffizienten gewichteten verzögerten internen Signale ($Q_i$) entspricht, wobei ein jeweiliges gewichtetes, verzögertes internes Signal vor der Summation in Abhängigkeit von der Verzögerung des internen verzögerten Signals ($Q_i$) verzögert wird.

**21.** Filter (700, 800) nach Anspruch 10 und 19,
**dadurch gekennzeichnet ,**
**dass** jeder weiteren Abtasteinrichtung (118) eine weitere Verzögerungsgliedkette (106) mit seriell verschalteten Verzögerungsgliedern (106) zugeordnet ist und ein jeweiliges weiteres Vorladesignal ($U_j$) an der Verzögerungsgliedkette abgreifbar ist, wobei jedem Verzögerungsglied ($106_{ij}$) der jeweiligen weiteren Verzögerungsgliedkette eingangsseitig ein mit einem jeweiligen Gewichtungskoeffizienten ($C_{ij}$) gewichtetes internes verzögertes Signal zugeführt ist.

**22.** Filter (700) nach Anspruch 20 oder 21,
**dadurch gekennzeichnet ,**
**dass** die weiteren Abtasteinrichtungen (108) an eine weitere Integratorstufe gekoppelt sind, welcher ausgangsseitig eine Zeitumkehreinrichtung (701) nachgeschaltet ist, und dass ein Addierer (702) vorgesehen ist, welcher die Ausgangssignale $F_L$, $F_R$) der Integratorstufen addiert und als das digitale Ausgangssignal (FOUT) des Filters (700) ausgibt.

**23.** Filter (900) nach Anspruch 12 und 19,
**dadurch gekennzeichnet ,**
**dass** das Gewichtungsnetzwerk derart die Segmentsignale ($R_i$) erzeugt, dass ein jeweiliges Segmentsignal ($R_i$) einer Summe der mit Gewichtungskoeffizienten ($C_{ij}$) gewichteten Summen der internen Abtastsignale ($S_i$) mit weiteren verzögerten internen Abtastsignalen ($S_i'$) entspricht, wobei vor der Summation ein jeweiliges, von einer weiteren Abtasteinrichtung erzeugtes, weiteres internes Abtastsignal ($S_i'$) in Abhängigkeit von dem jeweiligen Leitungsknoten der Verzögerungsgliedkette verzögert wird.

**24.** Filter (900) nach Anspruch 12 und 19,
**dadurch gekennzeichnet ,**
**dass** das jeder weiteren Abtasteinrichtung ($118_j$) eine weitere Verzögerungsgliedkette (106) mit seriell verschalteten Verzögerungsgliedern zugeordnet ist, welcher ein jeweiliges weiteres Abtastsignal ($S_i'$) zugeführt ist, wobei an Ausgängen der weiteren Verzögerungsglieder verzögerte interne Abtastsignale abgreifbar sind und die Segmentsignale ($R_i$) derart erzeugt werden, dass ein jeweiliges Segmentsignal ($R_i$) einer Summe der mit den Gewichtungskoeffizienten ($C_{ij}$) gewichteten Summen der jeweiligen internen Abtastsignale mit den jeweiligen verzögerten internen Abtastsignalen entspricht.

**25.** Filter (900) nach Anspruch 23 oder 24,
**dadurch gekennzeichnet ,**
**dass** das die weiteren Abtasteinrichtungen (118) an eine weitere Integratorstufe gekoppelt sind, welcher eingangsseitig eine Zeitumkehreinrichtung (901) vorgeschaltet ist, welcher das digitale Eingangssignal (FIN) des Filters zugeführt ist.

**26.** Filter (700, 900) nach Anspruch 21 oder 24,
**dadurch gekennzeichnet ,**
**dass** die Verzögerungsglieder (106) der weiteren Verzögerungsgliedkette jeweils eine Verzögerung um $z^{-2}$ in der zweiten Taktrate erzeugen.

**27.** Filter (700, 900) nach einem der vorhergehenden Ansprüche 9 - 26,
**dadurch gekennzeichnet ,**
**dass** das Filter eine symmetrische FIR-Filterfunktion aufweist, wobei die Anzahl S der seriell geschalteten Verzögerungsglieder der Verzögerungsgliedkette (7, 20) $S = \left\lceil \dfrac{L}{2N} \right\rceil$ beträgt.

**28.** Polyphasenfilteranordnung (910, 920) mit:

a) einer Anzahl P von Filterzweigen (911), welche jeweils ein digitales Filter (912, 923) nach einem der Ansprüche 1 - 27 aufweisen;
b) einer Umschalteinrichtung (914, 921), welche ein digitales Polyphasenfiltereingangssignal (FIN) jeweils zeitverzögert als Zweigsignal in die Filterzweige einkoppelt; und mit
c) einer Summiereinrichtung (924), welche die Ausgangssignale der Filter zu einem Polyphasenfilterausgangssignal zusammenführt.

**29.** Polyphasenfilteranordnung (910, 920) nach Anspruch 28,
**dadurch gekennzeichnet ,**
**dass** die digitalen Filter (912, 922) jeweils mit einer um den Faktor P reduzierten Taktrate betrieben sind.

**30.** Polyphasenfilteranordnung (930, 940) nach Anspruch 28 oder 29,
**dadurch gekennzeichnet ,**
**dass** ein für die digitalen Filter der Filterzweige gemeinsames Gewichtungsnetzwerk (4, 19) vorgesehen ist, welches mit der zweiten Taktrate betrieben ist.

**31.** Polyphasenfilteranordnung (930, 940) nach einem der vorhergehenden Ansprüche 28 - 30,

27

**dadurch gekennzeichnet ,**
**dass** für die digitalen Filter der Filterzweige gemeinsame Abtasteinrichtungen (8, 108, 18, 948) vorgesehen ist.

32. Polyphasenfilteranordnung (930, 940) nach Anspruch 31,
**dadurch gekennzeichnet ,**
**dass** die Abtasteinrichtungen (8, 108, 18, 948) über Schalter an die jeweiligen Filtereinheiten (932, 933, 942, 943) oder an die rückgekoppelten Verzögerungsglieder der jeweiligen Integratoreinrichtungen gekoppelt sind.

33. Polyphasenfilteranordnung (930) nach einem der vorhergehenden Ansprüche 30 - 32,
**dadurch gekennzeichnet ,**
**dass** die Polyphasenfilteranordnung als Interpolationsfilter ausgebildet ist, wobei:

   a) jedem Filterzweig eine Gruppe von P seriell verschalteten Verzögerungsgliedern (931) zugeordnet ist;
   b) an Leitungsknoten zwischen den Verzögerungsgliedern (931) einer Gruppe jeweils ein Zweigsignal abgreifbar ist; und wobei
   c) die Gruppen seriell miteinander an einen Eingang (2) der Polyphasenfilteranordnung (930) verbunden sind.

34. Polyphasenfilteranordnung (940) nach einem der vorhergehenden Ansprüche 30 - 32,
**dadurch gekennzeichnet ,**
**dass** die Polyphasenfilteranordnung als Dezimationsfilter ausgebildet ist, wobei:

   a) jedem Filterzweig eine Gruppe von P seriell verschalteten Verzögerungsgliedern (947) zugeordnet ist;
   b) die Segmentsignale ($R_j$) taktweise über zwischen den Verzögerungsgliedern (947) vorgesehene Addierer einer jeweiligen Gruppe zugeführt sind; und wobei
   c) die Gruppen seriell miteinander an einen Ausgang (3) der Polyphasenfilteranordnung (940) verbunden sind.

35. Verfahren zum Bestimmen von Filterkoeffizienten ($C_{ij}$) eines digitalen Filters, welches eine vorgegebene Zielimpulsantwortfunktion ($H_{IAF}(z)$) realisiert, mit den folgenden Verfahrenschritten:

   a) Unterteilen der Zielimpulsantwortfunktion ($H_{IAF}(z)$) in Segmente, wobei jedes Segment (s) eine vorgegebene Anzahl von Stützstellen ($h_{s\,n+i}$) aufweist, und wobei jedem Segment (s) ein Satz von Gewichtungskoeffizienten ($C_{s,k}$) zugeordnet ist;

   b) Festlegen von unabhängigen Aufbauimpulsantwortfunktionen $\left( H_{DI}^{k,N}(z) \right)$, welche jeweils eine rekursive Filterordnung k aufweisen und von einem Abtastratenumsetzfaktor N abhängen;
   c) Bilden einer Linearkombination der Aufbauimpulsantwortfunktionen ($H^{k,N}(z)$ für jedes Segment s, wobei die Koeffizienten der Linearkombination den Gewichtungskoeffizienten ($C_{s,k}$) des jeweiligen Segmentes (s) entsprechen, und wobei die Gewichtungskoeffizienten ($C_{s,k}$) derart gewählt werden, dass die Linearkombination die Zielimpulsantwortfunktion ($H_{IAF}(z)$) in dem jeweiligen Segment annähert.

36. Verfahren nach Anspruch 35,
**dadurch gekennzeichnet ,**
**dass** die Gewichtungskoeffizienten ($C_{ij}$) mittels einer Ausgleichsrechung, insbesondere durch Interpolation bestimmt werden.

37. Verfahren nach Anspruch 35 oder 36,
**dadurch gekennzeichnet ,**
**dass** die Gewichtungskoeffizienten ($C_{ij}$) mittels eines Verfahrens der kleinsten Abweichungsquadrate bestimmt werden.

38. Verfahren nach einem der vorhergehenden Ansprüche 35 - 37,
**dadurch gekennzeichnet ,**
**dass** die Aufbauimpulsantwortfunktionen ($H^{k,N}_{DI}(z)$ jeweils einem Integrations- und Löschfilter (IAD) mit einer rekursiven Ordnung k und einer Rücksetzperiode von N entsprechen.

39. Verfahren nach einem der vorhergehenden Ansprüche 35 - 38,
**dadurch gekennzeichnet ,**

**dass** eine jeweilige unabhängige Aufbauimpulsantwortfunktion

lautet: $H_{DI}^{K,N}(z) = \sum_{n=0}^{N-1} \binom{n+K-1}{K-1} z^{-n}$ , wobei K einer vorgegebenen maximalen rekursiven Filterordnung entspricht.

**40.** Verfahren nach einem der vorhergehenden Ansprüche 35 - 39,
**dadurch gekennzeichnet ,**

**dass** die Zielimpulsantwortfunktion ($H_{IAF}(z)$) eine Länge L aufweist und die Anzahl S der Segmente $S = \left\lceil \dfrac{L}{N} \right\rceil$

beträgt.

**41.** Verfahren nach einem der vorhergehenden Ansprüche 35 - 40,
**dadurch gekennzeichnet ,**
**dass** die Anzahl der Stützstellen dem Abtastratenumsetzfaktor N entspricht.

**42.** Verfahren nach einem der vorhergehenden Ansprüche 35 - 41,
**dadurch gekennzeichnet ,**
**dass** die Gewichtungskoeffizienten $C_{i,j}$ gemäß eines Gleichungssystems

$$\underbrace{\begin{pmatrix} h_{s \cdot N + 0} \\ h_{s \cdot N + 1} \\ \vdots \\ h_{s \cdot N + N - 1} \end{pmatrix}}_{\underline{h}} = \underbrace{\begin{pmatrix} w_{0,1} & w_{0,2} & \cdots & w_{0,K} \\ w_{1,1} & w_{1,2} & \cdots & w_{1,K} \\ \vdots & \vdots & \ddots & \vdots \\ w_{N-1,1} & w_{N-1,2} & \cdots & w_{N-1,K} \end{pmatrix}}_{\underline{W}} \cdot \underbrace{\begin{pmatrix} C_{s,0} \\ C_{s,1} \\ \vdots \\ C_{s,K-1} \end{pmatrix}}_{\underline{c}}$$

bestimmt werden, wobei $\underline{h}$ ein Stützstellenvektor, $\underline{c}$ ein Gewichtungskoeffizientenvektor und $\underline{W}$ eine Aufbauimpulsantwort-matrix darstellt, mit: $w_{n,K} = \binom{n+K-1}{K-1}$ .

**43.** Verfahren nach einem der vorhergehenden Ansprüche 35 - 42,
**dadurch gekennzeichnet ,**
**dass** die Zielimpulsantwortfunktion ($H_{IAF}(z)$) symmetrisch gewählt wird, und die Gewichtungskoeffizienten ($C_{i,j}$) derart bestimmt werden, dass jeweils ein Paar von Gewichtungskoeffizienten ($C_{i,j}$) denselben Wert aufweist.

**44.** Verfahren nach einem der Ansprüche 35 - 43,
**dadurch gekennzeichnet ,**
**dass** das Verfahren die Gewichtungskoeffizienten ($C_{ij}$) für ein digitales Filter nach einem der Ansprüche 1 -34 bestimmt, wobei die Filtereinheiten (9, 17) zu den Aufbauimpulsantwortfunktionen ($H^{k,n}_{DI}$ (z)) proportionale Filterfunktionen aufweisen, und wobei ein jeweiliges verzögertes internes Signal oder ein jeweiliges Segmentsignal einem Segment (s) zugeordnet wird.

**45.** Verfahren zum Entwerfen eines digitalen Filters nach einem der Ansprüche 1 - 34 mit den Verfahrensschritten:

a) Festlegen einer Zielimpulsantwortfunktion ($H_{IAF}(z)$), einer maximalen rekursiven Filterordnung K, des Abtastratenumsetzfaktors N und einer Anzahl von Segmenten S;
b) Bestimmen der Gewichtungskoeffizienten (Cij) gemäß eines Verfahrens nach einem der Ansprüche 35 - 44;
c) Ausbilden eines digitalen Filters mit dem Gewichtungsnetzwerk (4, 19), wobei für jeden Gewichtungskoeffizienten ($C_{ij}$), welcher ungleich Null ist, ein Multiplizierer ($6_{ij}$) und ein Addierer ($5_{ij}$) vorgesehen wird und wobei jeweils die Aufbauimpulsantwortfunktionen ($H^{k,n}_{DI}(z)$) realisierende Filtereinheiten (9, 17) vorgesehen werden.

46. Verfahren nach Anspruch 45,
**dadurch gekennzeichnet ,**
**dass** die maximale rekursive Filterordnung (K) derart gewählt wird, dass eine maximale Abweichung ($E_{max}$) der realisierten Filterimpulsantwortfunktion ($H_{GIAD}(z)$) von der Zielimpulsantwortfunktion ($H_{IAF}$) unterhalb einer vorgegebenen Toleranzschwelle liegt.

47. Verfahren nach Anspruch 45 oder 46,
**dadurch gekennzeichnet ,**
**dass** im Schritt b) für mindestens ein Segment (s) ferner vorgesehen ist:

b1) Festlegen eines Probegewichtungskoeffizientensatzes bei dem mindestens einer der K Gewichtungskoeffizienten zu Null gesetzt wird;
b2) Bestimmen der nicht zu Null gesetzten Gewichtungskoeffizienten ($C_{ij}$) des Probegewichtungskoeffizientensatzes derart, dass die Linearkombination die Zielimpulsantwortfunktion ($H_{IAF}(z)$) in dem jeweiligen Segment annähert;
b3) Bestimmen einer jeweiligen maximale Abweichung ($E_{max}$) der mittels des Probegewichtungskoeffizientensatzes realisierten Filterimpulsantwortfunktion von der Zielimpulsantwortfunktion ($H_{IAF}(z)$) in dem Segment s.

48. Verfahren nach Anspruch 47,
**dadurch gekennzeichnet ,**
**dass** so viele Probegewichtungskoeffizientensätze bestimmt werden, dass für alle Kombinationen von zu Null gesetzten Gewichtungskoeffizienten ($C_{ij}$) die jeweilige maximale Abweichung bestimmt wird.

49. Verfahren nach Anspruch 47 oder 48,
**dadurch gekennzeichnet ,**
**dass** für die Realisierung des Gewichtungsnetzwerkes (4, 19) diejenigen Probegewichtungskoeffizientensätze ausgewählt werden, die die höchste Anzahl von zu Null gesetzte Gewichtungskoeffizienten aufweisen und wobei die maximalen Abweichungen unterhalb einer vorgegebenen Toleranzschwelle liegen.

# FIG 1

# FIG 2A

# FIG 2B

# FIG 3

# FIG 4

# FIG 5

# FIG 6

# FIG 7

# FIG 8

# FIG 9

# FIG 10

# FIG 11

## FIG 12

## FIG 13

FIG 14

FIG 15

# FIG 16

FIG 17

# FIG 18

910

FIN$_1$ 913$_1$ 912$_1$ 911$_1$

| | $Z^{-0/P}$ | GIAD ($\uparrow$N·P) | |

911$_2$

FIN

914

| | $Z^{-1/P}$ | GIAD ($\uparrow$N·P) | $+$ | FOUT |

924

913$_2$ 912$_2$

911$_P$

FIN$_P$ | $Z^{-1+1/P}$ | GIAD ($\uparrow$N·P) |

913$_P$ 912$_P$

# FIG 19

922$_1$ 923$_1$

FIN$_1$

| ($\downarrow$N·P) GIAD | $Z^{-0/P}$ | |

924

FIN

| ($\downarrow$N·P) GIAD | $Z^{-1/P}$ | $+$ | FOUT |

921

FIN$_P$ | ($\downarrow$N·P) GIAD | $Z^{-1+1/P}$ |

922$_P$ 923$_P$

FIG 20

FIG 21

FIG 22A

FIG 22B

FIG 22C

# FIG 23

## FIG 24

Europäisches
Patentamt

**EUROPÄISCHER RECHERCHENBERICHT**

Nummer der Anmeldung

EP 05 02 2259

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 329 381 A (THOMSON CONSUMER ELECTRONICS, INC) 23. August 1989 (1989-08-23)  * Zusammenfassung * * Seite 3, Zeile 1 - Seite 4, Zeile 33; Abbildung 1 * | 1-8, 10-15, 17, 35-42,45 | INV. H03H17/04 |
| A | | 9,16, 18-34, 43,44, 46-49 | |
| X | WO 99/16169 A (SIEMENS AKTIENGESELLSCHAFT; DRAXELMAYR, DIETER) 1. April 1999 (1999-04-01) * Seite 1, Zeile 30 - Seite 2, Zeile 8; Abbildung 2 * | 1-8, 10-15 | |
| A | | 9,16-34, 45-49 | |
| X | D. BABIC; J. VESMA; T. SARAMÄKI; M. RENFORS: "Implementation of the Transposed Farrow Structure" PROCEEDINGS OF THE IEEE INTERNATIONAL SYMPOSIUM ON CIRCUITS AND SYSTEMS, Bd. 4, 2002, Seiten IV/5-IV/8, XP002371437 Piscataway, NJ, USA * Seiten IV-6, rechte Spalte - Seiten IV-8, linke Spalte; Abbildungen 3,4 * | 1-8, 10-15 | RECHERCHIERTE SACHGEBIETE (IPC)  H03H |
| A | | 9,16-34, 45-49 | |

-/--

Der vorliegende Recherchenbericht wurde für alle Patentansprüche erstellt

| Recherchenort | Abschlußdatum der Recherche | Prüfer |
|---|---|---|
| München | 4. August 2006 | Trafidlo, R |

**Europäisches
Patentamt**

**EUROPÄISCHER RECHERCHENBERICHT**

Nummer der Anmeldung

EP 05 02 2259

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| D,X | CANDY J C ET AL: "A VOICEBAND CODEC WITH DIGITAL FILTERING" IEEE TRANSACTIONS ON COMMUNICATIONS, IEEE SERVICE CENTER, PISCATAWAY, NJ, US, Bd. COM-29, Nr. 6, Juni 1981 (1981-06), Seiten 815-830, XP008044075 ISSN: 0090-6778 * Seite 816, rechte Spalte - Seite 818, linke Spalte * * Seite 822, linke Spalte - rechte Spalte; Abbildung 10 * | 1-8, 10-15 | |
| A | | 9,16-34, 45-49 | |
| A | R. E. CROCHIERE; L. R. RABINER: "Multirate Digital Signal Processing" 1983, PRENTICE-HALL INC. , UPPER SADDLE RIVER, NJ, US , XP002374851 * Seite 60 - Seite 70 * | 1-34 | |
| A | EP 1 298 799 A (SONY INTERNATIONAL GMBH) 2. April 2003 (2003-04-02) * Zusammenfassung * * Spalte 6, Absatz 29 - Spalte 8, Absatz 39; Abbildungen 1,2 * | 19-27 | RECHERCHIERTE SACHGEBIETE (IPC) |
| A | A. GROTH; G. EVANGELISTA; H. G. GOECKLER: "Parallelisation of Digital Systems Processing Arbitrarily Sampled Signals" PROCEEDINGS OF THE EUROPEAN CONFERENCE ON CIRCUIT THEORY AND DESIGN, Bd. 3, 1. September 2003 (2003-09-01), Seiten 125-128, XP002393642 Cracow, Poland * das ganze Dokument * | 28-34 | |

-/--

Der vorliegende Recherchenbericht wurde für alle Patentansprüche erstellt

| Recherchenort | Abschlußdatum der Recherche | Prüfer |
|---|---|---|
| München | 4. August 2006 | Trafidlo, R |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 05 02 2259

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | GOCKLER H G ET AL: "Minimal block processing approach to fractional sample rate conversion" SIGNAL PROCESSING, AMSTERDAM, NL, Bd. 81, Nr. 4, April 2001 (2001-04), Seiten 673-691, XP004234871 ISSN: 0165-1684 * Zusammenfassung * * Seite 675 - Seite 681; Abbildungen 2-5 * | 28-34 | |
| A | EP 1 134 892 A (ROBERT BOSCH GMBH) 19. September 2001 (2001-09-19) * das ganze Dokument * | 28-34 | |
| X | VESMA J ET AL: "INTERPOLATION FILTERS WITH ARBITRARY FREQUENCY RESPONSE FOR ALL-DIGITAL RECEIVERS" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, Bd. 2, 12. Mai 1996 (1996-05-12), Seiten 568-571, XP000948193 ISBN: 0-7803-3074-9 * Seite 569, linke Spalte - Seite 570, rechte Spalte; Abbildungen 3-5 * * Seite 571; Abbildung 9 * | 35-44 | RECHERCHIERTE SACHGEBIETE (IPC) |
| A | ----- -/-- | 1-34, 45-49 | |

Der vorliegende Recherchenbericht wurde für alle Patentansprüche erstellt

| Recherchenort | Abschlußdatum der Recherche | Prüfer |
|---|---|---|
| München | 4. August 2006 | Trafidlo, R |

EPO FORM 1503 03.82 (P04C03)

Europäisches
Patentamt

**EUROPÄISCHER RECHERCHENBERICHT**

Nummer der Anmeldung

EP 05 02 2259

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HENTSCHEL T ET AL: "CONTINUOUS-TIME DIGITAL FILTERS FOR SAMPLE-RATE CONVERSION IN RECONFIGURABLE RADIO TERMINALS ZEITKONTINUIERLICHE DIGITALFILTER ZUR ABTASTRATENWANDLUNG IN REKONFIGURIERBAREN FUNKENDGERAETEN" FREQUENZ, SCHIELE UND SCHON, BERLIN, DE, Bd. 55, Nr. 5/6, 1. Mai 2001 (2001-05-01), Seiten 185-188, XP001019533 ISSN: 0016-1136 * Seite 186, linke Spalte - Seite 187, rechte Spalte; Abbildungen 1-3 * | 35-44 | |
| A | | 1-34, 45-49 | |
| | ----- | | |
| | | | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| München | 4. August 2006 | Trafidlo, R |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
 
& : Mitglied der gleichen Patentfamilie, übereinstimmendes
    Dokument

EPO FORM 1503 03.82 (P04C03)

**Europäisches**
**Patentamt**

Nummer der Anmeldung

EP 05 02 2259

## GEBÜHRENPFLICHTIGE PATENTANSPRÜCHE

Die vorliegende europäische Patentanmeldung enthielt bei ihrer Einreichung mehr als zehn Patentansprüche.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

**Europäisches Patentamt**

## MANGELNDE EINHEITLICHKEIT DER ERFINDUNG ERGÄNZUNGSBLATT B

Nummer der Anmeldung

EP 05 02 2259

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-34,45-49

    Digitales Filter zur Abtastratenumsetzung mit einer Anzahl von einzeln rückgekoppelten rücksetzbaren Verzögerungsgliedern mit ausgangsseitig nachgeschalteter Verschiebeeinrichtung; und Verfahren zum Entwerfen eines solchen Filters (wenn die Ansprüche 19-34 und 45-49 auf den Anspruch 9 oder 16 rückbezogen sind)
    ---

2. Ansprüche: 1,10,19-34,45-49

    Digitales Filter zur Abtastratenumsetzung, das eine symmetrische FIR-Filterfunktion und eine Zeitumkehreinrichtung aufweist; und Verfahren zum Entwerfen eines solchen Filters (wenn die Ansprüche 19-27 NICHT auf den Anspruch 9 oder 16 rückbezogen sind und die Ansprüche 28-34, 45-49 auf die Ansprüche 19-27 rückbezogen sind)
    ---

3. Ansprüche: 1,28-34,45-49

    Polyphasenfilteranordnung und Verfahren zum Entwerfen einer solchen Anordnung
    ---

4. Ansprüche: 35-44

    Verfahren zum Bestimmen von Filterkoeffizienten eines digitalen Filters
    ---

**EP 1 775 833 A1**

## ANHANG ZUM EUROPÄISCHEN RECHERCHENBERICHT
## ÜBER DIE EUROPÄISCHE PATENTANMELDUNG NR.

EP 05 02 2259

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-08-2006

| Im Recherchenbericht angeführtes Patentdokument | Datum der Veröffentlichung | Mitglied(er) der Patentfamilie | Datum der Veröffentlichung |
|---|---|---|---|
| EP 0329381 A | 23-08-1989 | CA 1298918 C<br>DE 68922632 D1<br>DE 68922632 T2<br>ES 2072294 T3<br>FI 890630 A<br>JP 1284110 A<br>JP 2999478 B2<br>KR 9707356 B1<br>US 4819252 A | 14-04-1992<br>22-06-1995<br>12-10-1995<br>16-07-1995<br>17-08-1989<br>15-11-1989<br>17-01-2000<br>07-05-1997<br>04-04-1989 |
| WO 9916169 A | 01-04-1999 | CA 2272656 A1<br>CN 1126251 C<br>DE 19741922 A1<br>EP 0940009 A1<br>JP 2001506107 T<br>TW 439356 B<br>US 6034628 A | 01-04-1999<br>29-10-2003<br>25-03-1999<br>08-09-1999<br>08-05-2001<br>07-06-2001<br>07-03-2000 |
| EP 1298799 A | 02-04-2003 | JP 2003158445 A<br>US 2003065693 A1 | 30-05-2003<br>03-04-2003 |
| EP 1134892 A | 19-09-2001 | KEINE | |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **CANDY et al.** Voiceband Codec with Digital Filtering. *IEEE Transactions on Communications,* Juni 1981, vol. com. -29 (6